(19) Europäisches Patentamt
European Patent Office
Office européen des brevets

(11) EP 2 239 788 A1

(12) EUROPEAN PATENT APPLICATION
published in accordance with Art. 153(4) EPC

(43) Date of publication:
13.10.2010 Bulletin 2010/41

(51) Int Cl.:
H01L 31/06 (2006.01)     H01L 31/18 (2006.01)

(21) Application number: 09705972.9

(22) Date of filing: 30.01.2009

(86) International application number:
PCT/JP2009/051608

(87) International publication number:
WO 2009/096539 (06.08.2009 Gazette 2009/32)

(84) Designated Contracting States:
AT BE BG CH CY CZ DE DK EE ES FI FR GB GR
HR HU IE IS IT LI LT LU LV MC MK MT NL NO PL
PT RO SE SI SK TR
Designated Extension States:
AL BA RS

(30) Priority: 30.01.2008 JP 2008019722

(71) Applicant: Kyocera Corporation
Kyoto-shi
Kyoto 612-8501 (JP)

(72) Inventors:
• NIIRA, Koichiro
Higashiomi-shi
Shiga 527-8555 (JP)
• IWAMEJI, Kazuaki
Higashiomi-shi
Shiga 527-8555 (JP)
• KOMODA, Manabu
Higashiomi-shi
Shiga 527-8555 (JP)

(74) Representative: Witte, Weller & Partner
Königstrasse 5
70173 Stuttgart (DE)

(54) **SOLAR BATTERY ELEMENT AND SOLAR BATTERY ELEMENT MANUFACTURING METHOD**

(57)    A high-efficiency solar cell device producible in a simplified manner, and a method of manufacturing the same are provided. An insulation layer is formed on the back surface side of a semiconductor substrate of a first conductivity type. Removing part of the insulation layer exposes part of the semiconductor substrate to form a plurality of first through holes. A first layer of the first conductivity type is formed on the insulation layer and on the part of the semiconductor substrate exposed in the plurality of first through holes, whereby first junction regions are formed. Removing part of the first layer and the insulation layer exposes part of the semiconductor substrate to form a plurality of second through holes. A second layer of an opposite conductivity type is formed on the first layer and on the part of the semiconductor substrate exposed in the plurality of second through holes, whereby second junction regions are formed. A first conductive section for connecting the first junction regions to each other is formed on the first layer. A second conductive section for connecting the second junction regions to each other is formed on the second layer. The first through holes and the second through holes are formed by irradiation with a laser beam.

FIG. 1

## Description

Technical Field

The present invention relates to a solar cell device and a method of manufacturing a solar cell device.

Background Art

At present, the predominant products of solar cell devices are bulk crystalline silicon solar cell devices using crystalline silicon substrates. Such a crystalline silicon solar cell device is produced by processing a crystalline silicon substrate in the step of device formation (see, for example, Japanese Patent Application Laid-Open No. 8-274356 (1996) (Patent Document 1)). It is a crystalline silicon solar cell module that has a structure in which such crystalline silicon solar cell devices are connected to each other.

Some crystalline silicon solar cell devices are of the type having a front electrode (often comprised of metal electrodes referred to as bus bars and fingers) made of metal on the light receiving surface thereof, and some are what is called BC (back contact) type solar cell devices in which no electrode is provided on the light receiving surface thereof but both positive and negative electrodes are disposed on the non-light receiving surface side (see, for example, 13th-EU-PSEC (1995), p. 1582 (Non-Patent Document 1)).

A conventional typical method of manufacturing a BC type solar cell device is a complicated method including a plurality of mask formation and patterning processes (see, for example, 15th-NREL-Workshop (2005), pp. 11-22 (Non-Patent Document 2)).

Disclosure of Invention

It is an object of the present invention to provide a BC type solar cell device which is producible in a simplified manner and which has excellent output characteristics, and a method of manufacturing the same.

A solar cell device according to one aspect of the present invention comprises: a semiconductor substrate of a first conductivity type comprising a light receiving surface and a back surface opposite the light receiving surface; an insulation layer formed on the back surface side of the semiconductor substrate and comprising at least one first through hole and at least one second through hole; a first layer of the first conductivity type formed on the insulation layer and formed on part of the semiconductor substrate in the at least one first through hole; and a second layer of an opposite conductivity type formed on the first layer and formed on part of the semiconductor substrate in the at least one second through hole.

A method of manufacturing a solar cell device according to another aspect of the present invention comprises: preparing a semiconductor substrate of a first conductivity type comprising a light receiving surface and a back surface opposite the light receiving surface; forming an insulation layer on the back surface side of the semiconductor substrate; removing a first region of the insulation layer to form at least one first through hole in the insulation layer; forming a first layer of the first conductivity type on the insulation layer and on part of the semiconductor substrate exposed in the at least one first through hole; removing a second region of the first layer and the insulation layer to form at least one second through hole in the insulation layer; and forming a second layer of an opposite conductivity type on the first layer and on part of the semiconductor substrate exposed in the at least one second through hole.

Brief Description of Drawings

[Fig. 1] is a schematic sectional view partly showing a structure of a solar cell device 20A according to a first embodiment of the present invention.
[Fig. 2] is a view showing the external appearance of the solar cell device 20A. (a) is a view of the solar cell device 20A as seen from the front side, and (b) is a view of the solar cell device 20A as seen from the back side.
[Fig. 3] is a schematic view, on an enlarged scale, of a region R shown in Fig. 2.
[Fig. 4] is a sectional view taken along the line X-X of Fig. 3.
[Fig. 5] is a sectional view taken along the line Y-Y of Fig. 3.
[Fig. 6] is a schematic view showing modifications of the arrangement of through holes 10.
[Fig. 7] is a view for illustrating the reduction in leakage current. (a) is a view schematically showing the arrangement of a semiconductor substrate 1, a first conductivity type thin film layer 3, a second conductivity type thin film layer 4, and an insulation layer 7 in relation to each other in the solar cell device 20A, and (b) is a view schematically showing the arrangement of the components in relation to each other when the insulation layer 7 is absent.
[Fig. 8] is a view for illustrating the reduction in leakage current. (a) is a view showing a band structure in an area shown in Fig. 7(a). (b) is a view showing a band structure in an area shown in Fig. 7(b).
[Fig. 9] is a band diagram for illustrating the recombination suppressing effect of carriers by the provision of the first conductivity type thin film layer 3 on the insulation layer 7.
[Fig. 10] is a view schematically showing the manufacturing steps of the solar cell device 20A according to the first embodiment.

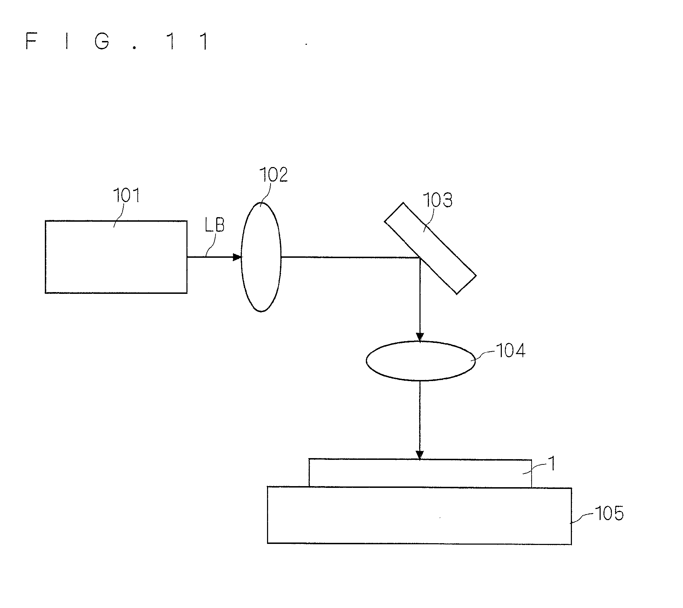

[Fig. 11] is a schematic diagram conceptually showing the construction of a laser machining apparatus 100 for use in a laser method.

[Fig. 12] is a view schematically showing the construction of a solar cell module 30. (a) is a sectional view of the solar cell module 30, and (b) is a plan view of the solar cell module 30 of (a) as seen from the front side.

[Fig. 13] is a view of the solar cell device 20A being produced by a procedure different from that in the first embodiment.

[Fig. 14] is a view of the solar cell device 20A being produced by a procedure different from that in the first embodiment.

[Fig. 15] is a view schematically showing changes in state occurring when a laser machining apparatus is used for melting by heating according to a modification shown in Fig. 14.

[Fig. 16] is a schematic sectional view partly showing a structure of a solar cell device 20B according to a second embodiment of the present invention.

[Fig. 17] is a view schematically showing the manufacturing procedure of the second solar cell device 20B.

[Fig. 18] is a schematic sectional view partly showing a structure of a solar cell device 20C according to a third embodiment of the present invention.

[Fig. 19] is a view schematically showing the manufacturing procedure of the third solar cell device 20C.

Best Mode for Carrying Out the Invention

<First Embodiment>

A solar cell device according to embodiments of the present invention generally has a structure in which an insulation layer is formed on a semiconductor substrate of a first conductivity type and in which a junction region between a first conductivity type thin film layer of the same conductivity type as the semiconductor substrate and the semiconductor substrate and a junction region between a second conductivity type thin film layer of an opposite conductivity type to the semiconductor substrate and the semiconductor substrate are isolated from each other by the insulation layer.

The expression aEn will be used hereinafter to denote a x $10^n$.

<<Structure of Solar Cell Device>>

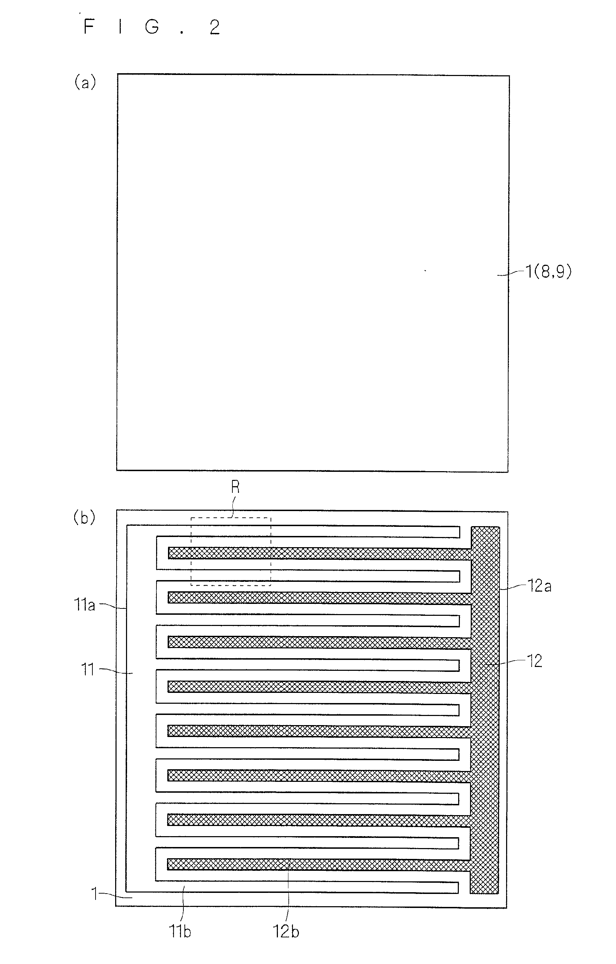

As shown in Fig. 2(a), a solar cell device 20A is a BC type solar cell device including a light receiving region on the front surface side thereof, and including a positive electrode and a negative electrode on the back surface side thereof.

A semiconductor substrate 1 used herein for the solar cell device 20A is, for example, a crystalline silicon substrate, such as a single crystalline silicon substrate and a polycrystalline silicon substrate, of a first conductivity type having a predetermined dopant element (an impurity for the control of the conductivity type).

When a p-type crystalline silicon substrate is used, the semiconductor substrate 1 is doped with, for example, B or Ga as a dopant element on the order of about 1E14 to 1E17 atoms/$cm^3$. The thickness of such a semiconductor substrate 1 is preferably not greater than 300 $\mu$m, more preferably not greater than 250 $\mu$m, and even more preferably not greater than 150 $\mu$m. In the embodiments according to the present invention, description will be given on instances where a p-type silicon substrate is used as the semiconductor substrate 1.

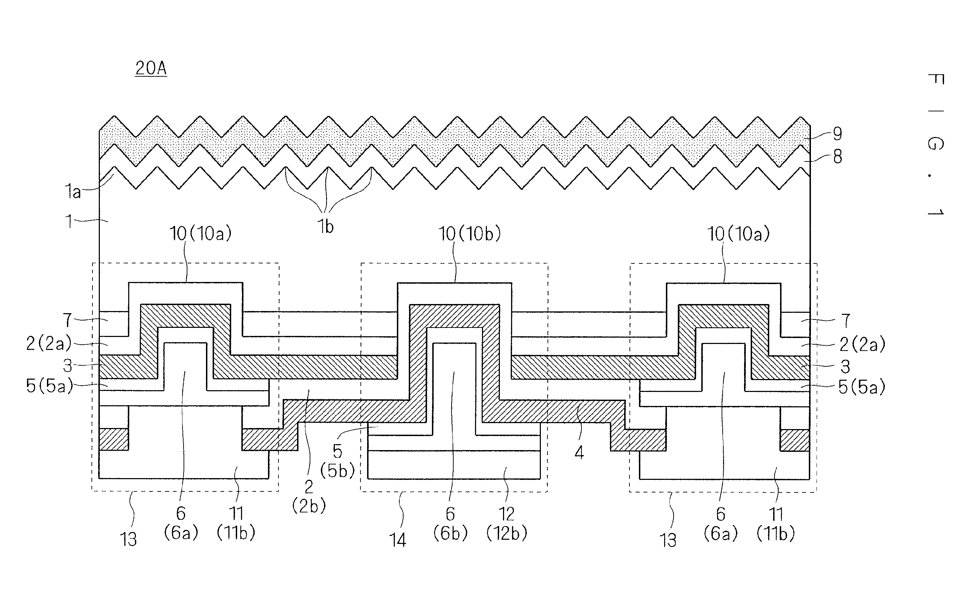

The semiconductor substrate 1 in the solar cell device 20A has a textured structure (uneven structure) 1a on the light receiving surface side (the upper surface side as seen in Fig. 1) thereof.

The textured structure (uneven structure) 1a has the function of reducing the reflectance of incident light at the surface of the semiconductor substrate, and includes an uneven surface comprised of a large number of minute protrusions 1b on the light receiving surface side of the semiconductor substrate 1. It is preferred that the protrusions 1b are not greater than 2 $\mu$m in width and in height, and are in the range of 0.1 to 2 in aspect ratio (height/width).

A passivation layer 8 has the function of achieving what is called a surface passivation effect, and is formed on the light receiving surface side of the semiconductor substrate 1. It is preferred that the passivation layer 8 is formed of a single layer or multi-layer configuration comprising a hydrogenated amorphous silicon (a-Si:H) film or a hydrogenated microcrystalline silicon ($\mu$c-Si:H) film, a SiC film, a silicon nitride film, and a silicon oxide film. The microcrystalline silicon as used herein shall refer to silicon in such a state that amorphous silicon fills the grain boundary of crystalline silicon grains. It is preferred that the passivation layer 8 is formed to have a thickness on the order of about 1 to 100 nm. The passivation layer 8 may be used as an anti-reflection film. There are cases where the a-Si:H film and the $\mu$c-Si:H film are formed as i-type films that are not doped with impurities and as p-type or n-type films doped with impurities.

An anti-reflection layer 9 has the function of reducing the reflection of incident light, and is formed on the passivation layer 8. It is preferred that the anti-reflection layer 9 is formed of a silicon nitride film (a $SiN_x$ film (where the composition (x) varies around $Si_3N_4$ stoichiometry)) or an oxide material film (a $TiO_2$ film, a MgO film, an ITO film, a $SnO_2$ film, a ZnO film or a $SiO_x$ film). When the anti-reflection layer 9 has the surface passivation effect, the passivation layer 8 may be dispensed with.

Next, the back surface side (the lower surface side as seen in Fig. 1) of the semiconductor substrate 1 corresponding to the back surface side of the solar cell device 20A will be described in detail.

A first electrode 11 and a second electrode 12 serving as output extraction electrodes are provided as what is called comb-shaped electrodes on the back surface side of the semiconductor substrate 1 shown in Fig.

2(b). The first electrode 11 and the second electrode 12 include bus bar sections (first line sections) 11a and 12a connected to wiring for connection to different solar cell devices 20A during the formation of the solar cell devices 20A into a module, and a plurality of finger sections (second line sections) 11b and 12b extending from the bus bar sections 11a and 12a, respectively. The first electrode 11 and the second electrode 12 are preferably higher in solderability than a conductive layer 6 to be described later. This improves solder connection to wiring 21 to be described later.

An intrinsic thin film layer 2 (including a first intrinsic thin film layer 2a and a second intrinsic thin film layer 2b), a first conductivity type thin film layer (a first layer) 3, a second conductivity type thin film layer (a second layer) 4, a transparent conductive layer 5 (including a first transparent conductive layer 5a and a second transparent conductive layer 5b), the conductive layer 6 (including a first conductive layer 6a and a second conductive layer 6b), and an insulation layer 7 are principally provided on the back surface side of the semiconductor substrate 1.

As shown in Figs. 1, 4 and 5, the insulation layer 7 is provided with a plurality of through holes 10. In the solar cell device 20A shown in Figs. 1, 4 and 5, recessed portions in communication with the respective through holes 10 are provided in the back surface of the semiconductor substrate 1, but are not essential. The back surface of the semiconductor substrate 1 may be held substantially flat. When the recessed portions are provided, it is preferred that the recessed portions have a depth of not greater than 1 $\mu$m.

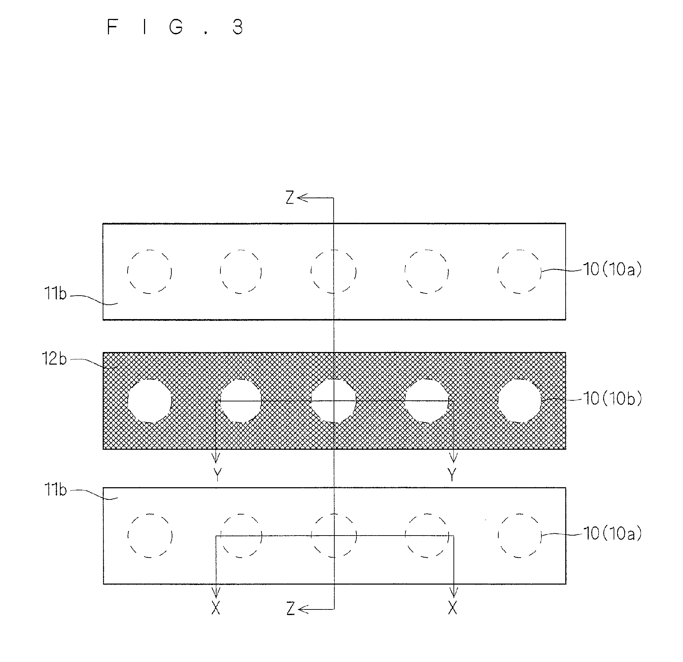

The through holes 10 are substantially equally spaced in the longitudinal directions of the finger sections 11b and 12b, as shown in Figs. 3, 4 and 5. It is preferred that the through holes 10 are in the form of dots substantially circular as seen in top plan view and having a diameter on the order of about tens of micrometers to hundreds of micrometers, as shown in Fig. 3. The shape of the through holes 10, however, is not limited to this but may be linear. Also, when the through holes 10 are in the form of dots, the through holes 10 may have other shapes such as a rectangular shape as seen in top plan view. Although the through holes 10 are rectangular in shape as seen in side sectional view with reference to Figs. 1, 4 and 5, the through holes 10 may have a trapezoidal shape with a width decreasing toward the inside of the semiconductor substrate 1.

In the present embodiment, a multi-layer portion lying between the first electrode 11 (more specifically, the finger sections 11b thereof) and the semiconductor substrate 1 is defined as a positive electrode 13, and a multi-layer portion lying between the second electrode 12 (more specifically, the finger sections 12b thereof) and the semiconductor substrate 1 is defined as a negative electrode 14. The through holes 10 include first through holes 10a disposed along the finger sections 11b of the positive electrode 13, and second through holes 10b disposed along the finger sections 12b of the negative electrode 14.

It is preferred that distances (center-to-center distances) between the individual first through holes 10a and between the second through holes 10b are on the order of about 100 $\mu$m to 1 mm. It is also preferred that the distance between the first through holes 10a and the second through holes 10b is on the order of about 100 $\mu$m to 1 mm.

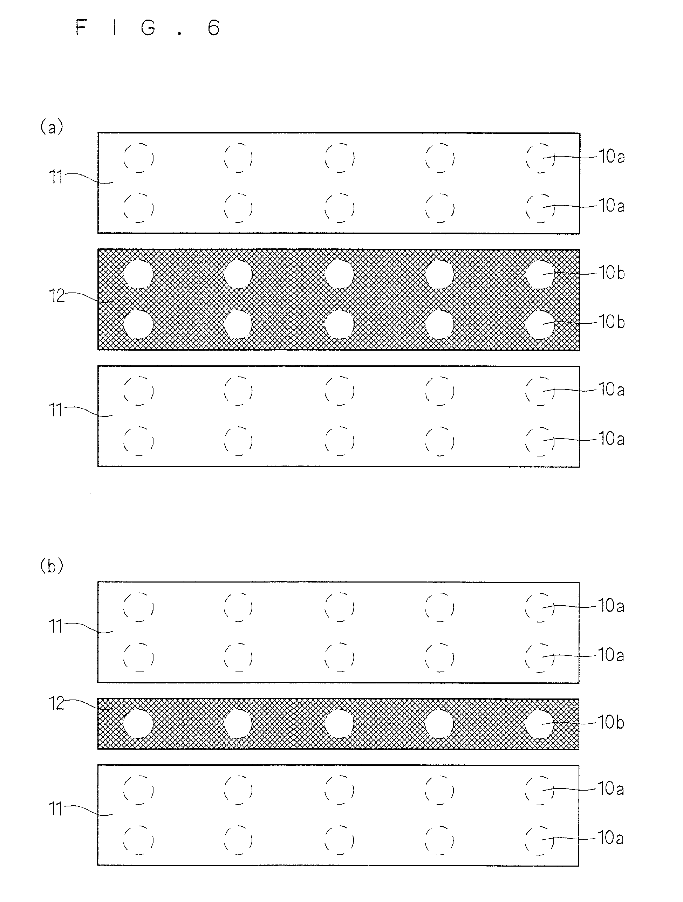

The through holes 10 may be arranged in a plurality of rows (in Fig. 6(a), illustrated in two rows) in the longitudinal directions of the individual finger sections 11b and 12b, for example, as shown in Fig. 6(a). Also, the first through holes 10a may be arranged in two rows in the longitudinal direction of the finger sections 11b, whereas the second through holes 10b be arranged in a row in the longitudinal direction of the finger sections 12b, as shown in Fig. 6(b).

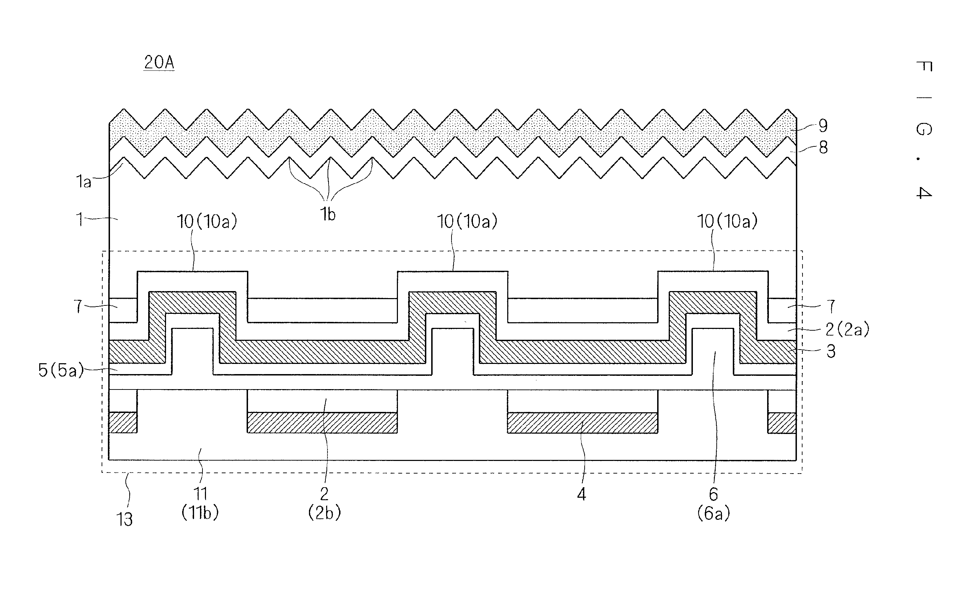

In the solar cell device 20A , as shown in Figs. 1 and 4, the first intrinsic thin film layer 2a and the first conductivity type thin film layer 3 are stacked in the first through holes 10a, on exposed portions of the semiconductor substrate 1 in the first through holes 10a, and on the insulation layer 7. In the positive electrode 13, the first transparent conductive layer 5a and the first conductive layer 6a are further stacked on the first conductivity type thin film layer 3. It should be noted that the first intrinsic thin film layer 2a and the first transparent conductive layer 5a are not essential. The first conductivity type thin film layer 3 may be formed directly in the first through holes 10a and on the insulation layer 7. In the positive electrode 13, the first conductive layer 6a may be formed directly on the first conductivity type thin film layer 3.

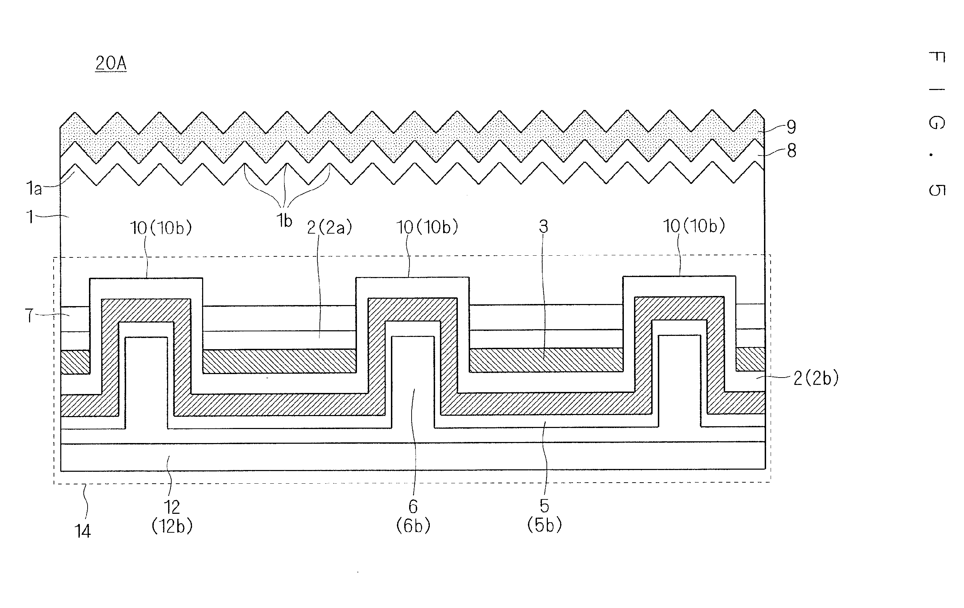

As shown in Figs. 1 and 5, on the other hand, the second intrinsic thin film layer 2b and the second conductivity type thin film layer 4 are stacked on the inner surfaces of the second through holes 10b and on portions of the first conductivity type thin film layer 3 formed around the second through holes 10b. In the negative electrode 14, the second transparent conductive layer 5b and the second conductive layer 6b are further stacked on the second conductivity type thin film layer 4. It should be noted that the second intrinsic thin film layer 2b and the second transparent conductive layer 5b are not essential. The second conductivity type thin film layer 4 may be formed directly in the second through holes 10b and on the insulation layer 7. In the negative electrode 14, the second conductive layer 6b may be formed directly on the second conductivity type thin film layer 4. As shown in Figs. 1 and 4, the second intrinsic thin film layer 2b and the second conductivity type thin film layer 4 extend to the top of the first conductive layer 6a.

In the positive electrode 13, as shown in Figs. 1 and 4, the finger sections 11b are formed on the first conductive layer 6a, the second intrinsic thin film layer 2b and the second conductivity type thin film layer 4. In the negative electrode 14, as shown in Figs. 1 and 5, the finger sections 12b are formed on the second conductive layer 6b.

It is preferred that the insulation layer 7 is formed of an oxide film such as a $SiO_x$ film, a $SiC_x$ film and a $TiO_2$ film, a $SiN_x$ film, or an intrinsic a-Si:H film, and has a thickness on the order of about 5 to 500 nm. In particular, a silicon oxide film and an a-Si film alleviate the influence of the fixed charge of the insulation layer 7 because of their ability to make the amount of the fixed charge relatively small. When a silicon oxide film is used as the insulation layer 7, the reflectance is improved.

It is preferred that the intrinsic thin film layer 2 is formed of an i-type hydrogenated amorphous silicon film (a-Si:H (i) film) or an i-type hydrogenated microcrystalline silicon thin film ($\mu$c-Si:H (i) film), and has a thickness on the order of about 0.5 to 10 nm.

It is preferred that the first conductivity type thin film layer (p-type silicon thin film layer) 3 is formed of a p-type hydrogenated amorphous silicon film (a-Si:H (p) film) or a p-type hydrogenated microcrystalline silicon film ($\mu$c-Si:H (p) film) doped with B, for example, as a dopant, and has a thickness on the order of about 5 to 50 nm and a dopant concentration on the order of about 1E18 to 1E21 atoms/$cm^3$.

It is preferred that the second conductivity type thin film layer (n-type silicon thin film layer) 4 is formed of an n-type hydrogenated amorphous silicon film (a-Si:H (n) film) or an n-type hydrogenated microcrystalline silicon film ($\mu$c-Si:H (n) film) doped with P (phosphorus), for example, as a dopant, and has a thickness on the order of about 5 to 50 nm and a dopant concentration on the order of about 1E18 to 1E21 atoms/$cm^3$.

The transparent conductive layer 5 has the function of increasing the adhesive strength between the first and second conductivity type thin film layers 3 and 4 and the conductive layer 6. The transparent conductive layer 5 further has the function of reflecting a component of incident light coming from the light receiving surface side which is transmitted through the semiconductor substrate 1, e.g. a light component having a long wavelength of not less than 900 nm, at a higher reflectance to cause the component to come into the semiconductor substrate 1 again. It is preferred that, for example, an ITO film, a $SnO_2$ film, a ZnO film and the like are used as the transparent conductive layer 5, and the transparent conductive layer 5 has a thickness on the order of about 5 to 100 nm.

The conductive layer 6 contains, for example, A1 or Ag as a principal component. It is preferred that the first and second conductive layers 6a and 6b constituting the conductive layer 6 have respective thicknesses on the order of about 0.1 to 3 $\mu$m.

In the solar cell device 20A according to the present embodiment, the first conductivity type thin film layer 3 and the second conductivity type thin film layer 4 that form heterojunctions with the semiconductor substrate 1 have an extremely high resistance of 1E13 to 1E6 $\Omega/\square$ in a direction substantially parallel to the back surface of the semiconductor substrate 1 (in a horizontal direction as seen in Figs. 1, 4 and 5). Such a high resistance is used to provide electrical isolation between the positive electrode 13 and the negative electrode 14.

**<<Relation between Device Structure and Device Characteristics>>**

In the solar cell device 20A having the aforementioned structure, a p/i/p+ junction region (a High-Low junction region) such that the semiconductor substrate 1 and the first conductivity type thin film layer 3 sandwich the first intrinsic thin film layer 2a therebetween is formed only in each of the first through holes 10a. Also, a p/i/n junction region (a heterojunction region) such that the semiconductor substrate 1 and the second conductivity type thin film layer 4 sandwich the second intrinsic thin film layer 2b therebetween is formed only in each of the second through holes 10b. Additionally, since the plurality of first through holes 10a and the plurality of second through holes 10b are in the form of dots, the junction regions are also in the form of dots. Thus, the solar cell device 20A is smaller in the area of the junction regions, as compared with a solar cell device in which the junction regions are provided in contact with the entire surfaces of the finger sections 11b and 12b. The solar cell device 20A accordingly has a reduced dark current to provide a greater Voc.

Also in the solar cell device 20A, the insulation layer 7 is present between the High-Low junction regions formed in the first through holes 10a and the heterojunction regions formed in the second through holes 10b to achieve a structure in which the High-Low junction regions and the heterojunction regions are spaced apart from each other. This reduces a leakage current in the solar cell device 20A.

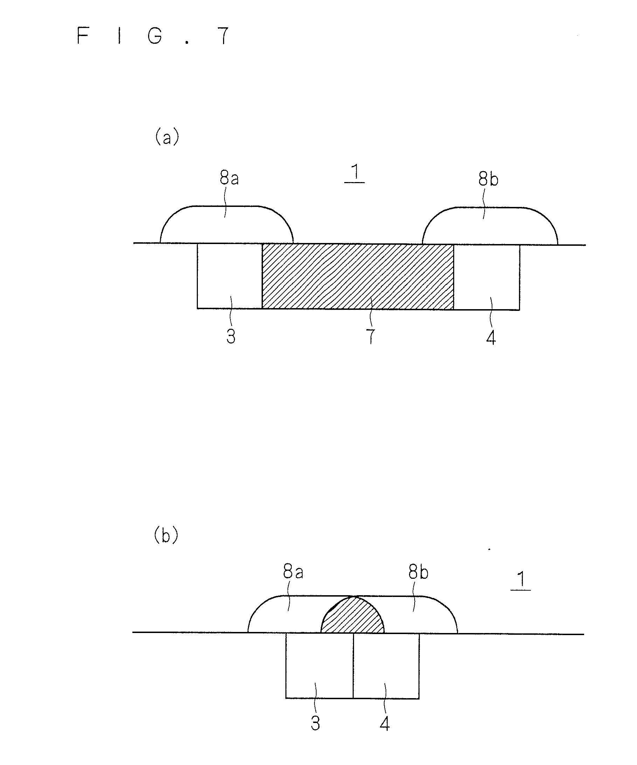

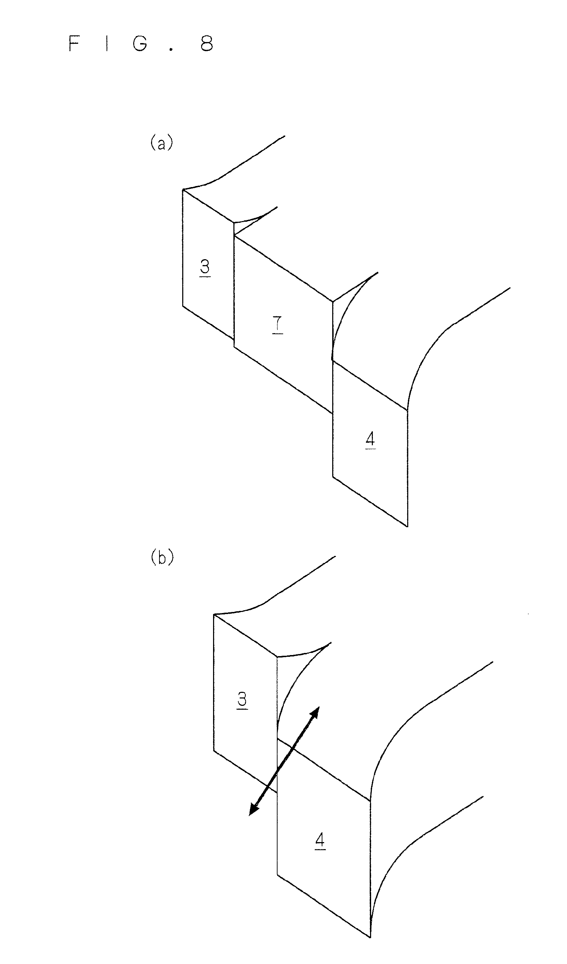

Fig. 7(a) is a view schematically showing the arrangement of the semiconductor substrate 1, the first conductivity type thin film layer 3, the second conductivity type thin film layer 4, and the insulation layer 7 in relation to each other in the solar cell device 20A according to the present embodiment. Fig. 7(b) is a view schematically showing the arrangement of the components in relation to each other if the insulation layer 7 is absent so that the first conductivity type thin film layer 3 and the second conductivity type thin film layer 4 are adjacent to each other. Figs. 8(a) and 8(b) are views showing band structures in areas shown in Figs. 7(a) and 7(b), respectively. For the purpose of simplicity of illustration, the intrinsic thin film layer 2 is not shown in Figs. 7 and 8.

As shown in Fig. 7(b), when the first conductivity type thin film layer 3 and the second conductivity type thin film layer 4 are adjacent to each other, an overlap occurs between a first space charge region 8a extending toward the semiconductor substrate 1 in the junction region between the semiconductor substrate 1 and the first conductivity type thin film layer 3, and a second space charge region 8b extending toward the semiconductor substrate 1 in the junction region between the semiconductor substrate 1 and the second conductivity type thin film layer 4. For this reason, as shown in Fig. 8(b), a leakage current as indicated by the arrow flows between the band on the first conductivity type thin film layer 3 side and the band on the n-type silicon thin film layer 4 side due to the tunneling effect. In the solar cell device 20A according to the present embodiment, however, since the insulation layer 7 between the first conductivity type thin film layer 3 and the second conductivity type thin film layer 4 as shown in Fig. 7(a) is present, the first space charge region 8a and the second space charge region 8b don't overlap each other to reduce the leakage current resulting from the tunneling effect.

Also in the solar cell device 20A according to the present embodiment, the first conductivity type thin film layer 3 is provided on the insulation layer 7 except where the through holes 10 are provided. Such a structure produces the effect of reducing the recombination of minority carriers.

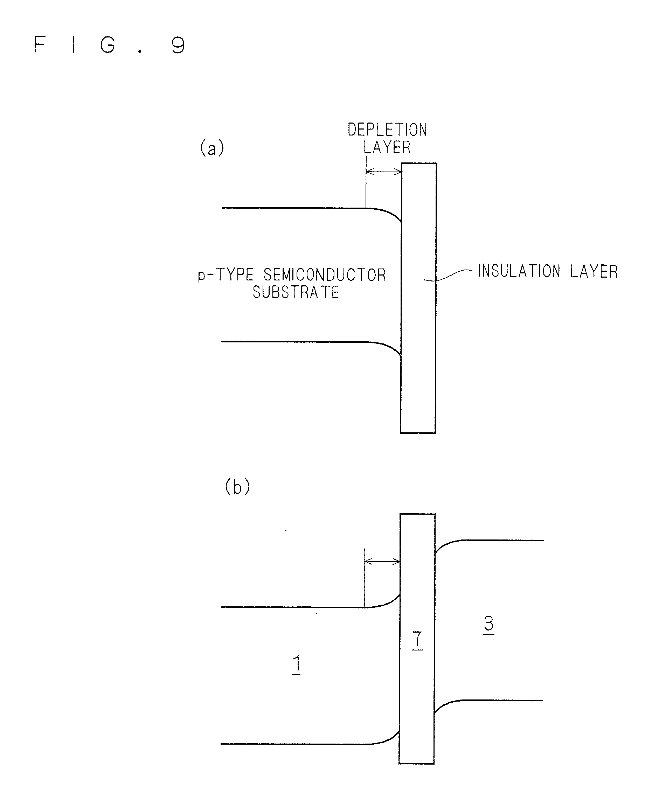

In general, when an insulation layer is formed on the surface of a semiconductor substrate of a p-type conductivity type, there is a likelihood that an inversion layer of the opposite polarity to the semiconductor or a depletion layer is formed near an interface between the semiconductor substrate and the insulation layer under the influence of the positive fixed charge of the insulation layer. At this time, as shown in Fig. 9(a), band bending may occur at the interface between the semiconductor substrate and the insulation layer so that the number of minority carriers increases. Accordingly, there may arise a problem that the recombination of the minority carriers increases. The term "band bending" used in the present embodiment refers to a phenomenon such that a band is bent by an exchange of electric charges between regions joined together.

In solar cell device 20A according to the present embodiment, however, the provision of the first conductivity type thin film layer 3 on the insulation layer 7 reduces the band bending so that minority carriers increase to achieve a band structure as shown in Fig. 9(b). This reduces the influence of the fixed charge of the insulation layer 7 to make the minority carriers more difficult to recombine, as compared with an instance in which the second conductivity type thin film layer 4 of an opposite conductivity type to the semiconductor substrate 1 is formed on the insulation layer 7. As a result, in the solar cell device 20A, dark current is reduced and a greater Voc is provided. For a semiconductor substrate of an n-type conductivity type, similar effects are produced when a silicon thin film of the n-type conductivity type is formed adjacent to the insulation layer.

In the solar cell device 20A, the provision of the insulation layer 7 on the back surface side of the semiconductor substrate 1 produces the passivation effect also on the back surface side. Further, since the intrinsic thin film layer 2, the first conductivity type thin film layer 3 and the second conductivity type thin film layer 4 that are hydrogenated amorphous silicon films are formed on the insulation layer 7, the effect that hydrogen diffuses to make hydrogen passivation of dangling bonds at the interface between the semiconductor substrate 1 and the insulation layer 7 is also provided. These effects contribute to the achievement of a high-efficiency solar cell device having excellent output characteristics.

As described hereinabove, in the solar cell device according to the present embodiment, the insulation layer 7 is present between the high-low junctions, which are formed between the semiconductor substrate 1 and the first conductivity type thin film layer 3 in the first through holes 10a, and the heterojunctions, which are formed between the semiconductor substrate 1 and the second conductivity type thin film layer 4 in the second through holes 10b. Thus, the insulation layer 7 serves as a potential barrier that reduces the recombination of the minority carriers to reduce a saturation dark current density. In addition, the solar cell device according to the present embodiment has a local heterostructure such that the junctions are formed locally only in areas where the first through holes 10a and the second through holes 10b are formed, to thereby reduce the area itself in which the dark current is generated. These allow the solar cell device according to the present embodiment to provide a high open-circuit voltage. Thus, the solar cell device having excellent output characteristics and high generating efficiency is achieved.

<<Method of Manufacturing Solar Cell Device>>

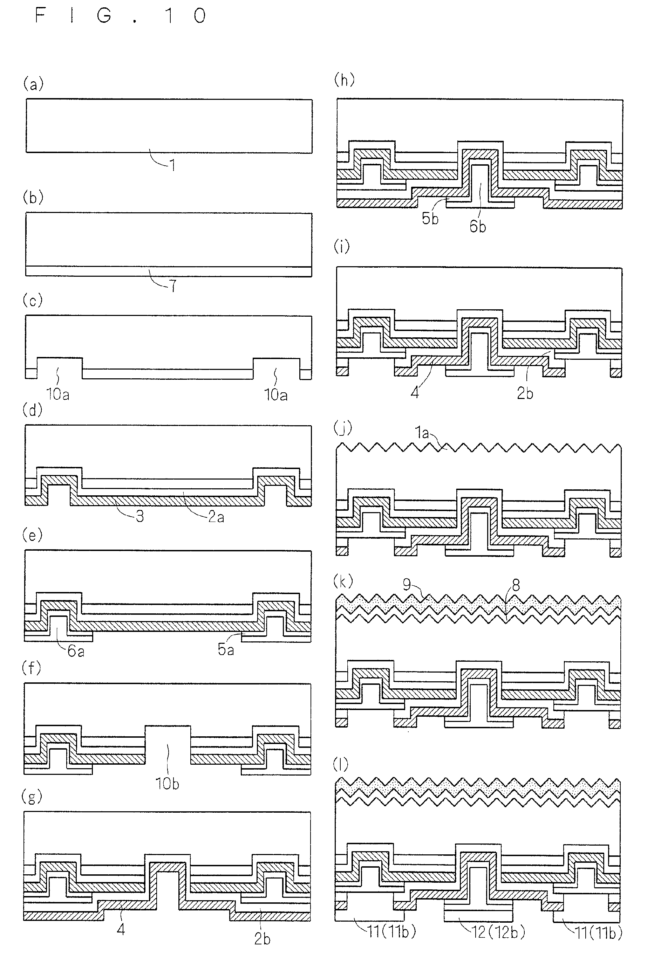

A method of manufacturing the solar cell device 20A will be described in detail in a step-by-step manner with reference to Fig. 10. In the present embodiment, an instance where a crystalline silicon substrate of the p-type conductivity type is used as the semiconductor substrate 1 will be described by way of example.

<Step of Preparing Semiconductor Substrate>

First, the semiconductor substrate 1 of the p-type conductivity type is prepared (Fig. 10(a)).

When an ingot is sliced to provide the semiconductor substrate 1, the surface parts on the front and back surface sides of the sliced semiconductor substrate 1 are etched and cleaned with deionized water, whereby organic components and metallic components are removed from the surface parts. In addition, a dilute hydrofluoric acid treatment and a deionized water rinse treatment are preferably performed to terminate the surface on which a silicon thin film layer is to be formed in the step to be described next with hydrogen. In such a case, a heterojunction interface with good quality is easily formed between the semiconductor substrate 1 and the silicon thin film layer.

<Formation of Insulation Layer>

Next, the insulation layer 7 is formed on a first main surface side of the semiconductor substrate 1 (Fig. 10(b)).

The insulation layer 7 is formed by a sputtering method, an evaporation method, a CVD method and the like to have a film thickness on the order of about 10 to 1000 nm. When a silicon oxide film is used as the insulation layer 7, the use of the CVD method capable of forming the insulation layer 7 at a low temperature ranging from room temperature (25 °C) to about 400 °C reduces the degradation in crystal quality of the semiconductor substrate 1.

<Step of Forming First Through Holes>

Next, the first through holes 10a are formed in the insulation layer 7. The first through holes 10a are provided in positions (in a first region) where the junction region between the semiconductor substrate 1 and the first conductivity type thin film layer 3 to be formed later is to be formed (Fig. 10(c)).

Examples of a method of machining and forming the first through holes 10a used herein include a sandblast method, a mechanical scribing method, a laser method and the like. In particular, the use of the laser method allows the machining and formation of the first through holes 10a with accuracy at a high speed, and also reduces damages to the semiconductor substrate 1 to a low level.

When a laser machining apparatus 100 is used, the semiconductor substrate 1 with the insulation layer 7 formed thereon is placed on a table 105, with the back surface side of the semiconductor substrate 1 previously positioned to face toward the irradiation of a laser beam LB. In this state, the laser beam LB is generated in a laser generator (light source) 101, and is caused to enter a first optical system 102 including a plurality of mirrors and lenses not shown. The laser beam LB is adjusted to have a desired shape in the first optical system 102. The laser beam LB passing through the first optical system 102 is reflected from a reflecting mirror 103, and the reflected laser beam LB then enters a second optical system 104. The laser beam LB the focal point of which is adjusted in the second optical system 104 is directed onto a position in which each of the first through holes 10a is to be formed on the semiconductor substrate 1 placed on the table 105. An example of the laser source used herein includes a YAG laser. The first through holes 10a are formed, for example, by irradiation with a laser beam having a wavelength of 0.532 $\mu$m (a second harmonic) or 0.355 $\mu$m (a third harmonic), a frequency of 1 to 500 kHz, and a pulse width of not greater than 1 nsec, more preferably 10 to 100 psec under conditions of a power output of not greater than 50 W, more preferably 1 to 10 W, and an irradiation diameter of 10 to 100 $\mu$m. Also, the adjustment of a combination of a pulse frequency and a scanning speed as appropriate allows the parts of laser machining that become the first through holes 10a to be in the form of dots (points) spaced 100 $\mu$m to

1 mm apart from each other. Alternatively, the parts of laser machining may be in linear form. The adjustment of the power output and the like of the laser apparatus allows the removal of the insulation layer 7 including the removal of the semiconductor substrate 1 as shown in Fig. 10(c), thereby forming recessed portions in communication with the first through holes 10a and having a depth of not greater than 1 $\mu$m on the back surface side of the semiconductor substrate 1. Instead, only the insulation layer 7 may be removed.

In this manner, the first through holes 10a are formed well in relation to the semiconductor substrate 1 by the use of the laser beam satisfying the conditions of a short wavelength that is a harmonic of the order n (where n is a positive integer) equal to or greater than 2, and a short pulse width of not greater than 1 nsec.

After the first through holes 10a are formed, etching is preferably performed in trace amounts using a gas plasma to ensure the surface flatness of the insulation layer 7 near the first through holes 10a.

<Step of Forming First Conductivity Type Thin Film Layer>

Next, a p-type silicon thin film layer is formed as the first conductivity type thin film layer 3 in the first through holes 10a and on the insulation layer 7. Specifically, an a-Si:H (p) film or a $\mu$c -Si:H (p) film is formed. This provides a heterojunction between the substrate and the thin film layer.

Preferably, for example, an a-Si:H (i) film or a $\mu$c-Si:H (i) film is formed as the first intrinsic thin film layer 2a that is a semiconductor layer of an intrinsic type (i-type) on the inner and exposed surfaces of the first through holes 10a and on the insulation layer 7, and thereafter the first conductivity type thin film layer 3 is formed thereon (Fig. 10(d)). The silicon thin film layers formed as the first intrinsic thin film layer 2a and the first conductivity type thin film layer 3 are also referred to hereinafter as a first silicon thin film layer.

Prior to the formation of the first silicon thin film layer, the substrate surfaces exposed in the first through holes 10a are preferably etched on the order of about several nanometers to tens of nanometers by a hydrogen radical treatment. This can remove damages, if any, done to the substrate surfaces during the formation of the first through holes 10a. The hydrogen radical treatment may include introducing a hydrogen gas into a vacuum chamber, and then performing a plasma treatment. In particular, the use of a remote plasma apparatus allows the treatment without exposing the semiconductor substrate 1 to a plasma atmosphere. Further, the activation of the hydrogen gas by the use of a thermal catalyzer for use in a Cat-CVD method is preferable because hydrogen radicals are effectively formed without using a plasma.

CVD methods, especially a plasma CVD (PECVD) method and a Cat-CVD method, are preferably used as a method of forming the first silicon thin film layer.

In particular, the use of a Cat-PECVD method allows the formation of the first silicon thin film layer with quite high quality, thereby improving the quality of the heterojunction formed between the semiconductor substrate 1 and the silicon thin film layer. This makes it easier to accomplish the high characteristics and high yield of the solar cell device 20A. The Cat-PECVD method used herein refers to a method in which gases are mixed downstream of a shower electrode in a plasma DVD apparatus by disposing a thermal catalyzer made of tungsten or tantalum in a gas path upstream of a plasma generation area, by disposing different thermal catalyzers in respective gas paths, or by disposing a thermal catalyzer only in a certain gas path.

When these CVD methods are used, silane and hydrogen may be used as the source gas for the first intrinsic thin film layer 2a, and diborane for doping with B as a dopant may be used in addition to silane and hydrogen as the source gas for the first conductivity type thin film layer 3.

Conditions for film deposition are as follows: a substrate temperature of 100 to 300 °C (for example, on the order of about 200 °C), a gas pressure of 10 to 500 Pa, a thermal catalyzer temperature of 1500 to 2000 °C when tungsten or the like is used as the thermal catalyzer, and a power density of 0.01 to 1 $W/cm^2$. These are adjusted to provide desirable conditions for film deposition. Thus, the silicon thin film layer with quite high quality is formed at a relatively low temperature on the order of about 200 °C, in a short time.

<Step of Forming First Conductive Layer>

Next, the first conductive layer 6a (a first portion of a first conductive section) is formed in the positive electrode 13. In this case, the formation of the first conductive layer 6a on the first transparent conductive layer 5a after the formation of the first transparent conductive layer 5a on the first conductivity type thin film layer 3 improves optical reflectance, and is hence preferable (Fig. 10(e)).

The first transparent conductive layer 5a may be formed by a sputtering method, an evaporation method, an ion plating method, a sol-gel method, a method of spraying and heating a raw material in liquid form, an inkjet method, and the like. In the case of forming an ITO film or a ZnO film as the first transparent conductive layer 5a by the sputtering method, it is preferable to provide a metal mask so as to cover the first conductivity type thin film layer 3 except where the first transparent conductive layer 5a is to be formed, and to perform a sputtering process using an ITO target doped with 0.5 to 4 wt% $SnO_2$ or an ZnO target doped with 0.5 to 4 wt% Al and causing Ar gas or a gas mixture of Ar gas and $O_2$ gas to flow, under conditions of a substrate temperature of 25 to 250 °C, a gas pressure of 0.1 to 1.5 Pa, and an electric power of 0.01 to 2 kW.

The first conductive layer 6a may be formed by a sputtering method, an evaporation method, an ion plating method, an inkjet method, and the like. In particular, the sputtering method is preferably used from the viewpoints of maintaining the heating temperature low, shortening the heating time, and providing good adhesion. In the case of forming a Ag film or an A1 film as the first conductive layer 6a by the sputtering method, it is preferable to provide a metal mask so as to cover the first conductivity type thin film layer 3 except where the first conductive layer 6a is to be formed, and to perform a sputtering process using a Ag or Al target respectively and causing Ar gas or a gas mixture of Ar gas and $O_2$ gas to flow, under conditions of a substrate temperature of 25 to 250°C, a gas pressure of 0.1 to 1.5 Pa, and an electric power of 0.01 to 2 kW. Alternatively, the first conductive layer 6a may be formed by forming an electrode pattern, which is made of a metal paste prepared by mixing a powder of metal such as Ag, Al and the like and an organic component together, by a coating method such as a printing method, and thereafter firing the electrode pattern. At this time, a resin binder that hardens at a temperature close to 200 °C is used to reduce damages to the silicon thin film layer. One or more resins selected from the group consisting of epoxy resin, phenolic resin, urethane resin, and polyester resin may be used as such a resin binder. The firing may be performed for approximately one hour.

<Step of Forming Second Through Holes>

Next, the second through holes 10b are formed by providing through holes extending through the first silicon thin film layer and the insulation layer 7. The second through holes 10b are provided in positions (in a second region) where the junction region between the semiconductor substrate 1 and the second conductivity type thin film layer 4 to be formed later is to be formed (Fig. 10(f)).

A method of machining and forming the second through holes 10b used herein may employ a technique similar to that for the first through holes 10a. Thus, the use of the laser method allows the machining of the second through holes 10b with accuracy at a high speed, and also reduces damages to the semiconductor substrate to a low level. As in the formation of the first through holes 10a, the adjustment of the power output and the like of the laser apparatus allows the removal of the insulation layer 7 including the removal of the semiconductor substrate 1 as shown in Fig. 10(f), thereby forming recessed portions in communication with the second through holes 10b and having a depth of not greater than 1 $\mu$m on the back surface side of the semiconductor substrate 1. Instead, only the insulation layer 7 may be removed. Further, the second through holes 10b are formed well in relation to the semiconductor substrate 1 by the use of the laser beam satisfying the conditions of a short wavelength that is a harmonic of the order n (where n is a positive integer) equal to or greater than 2, and a short pulse width of not greater than 1 nsec.

After the second through holes 10b are formed, etching is preferably performed in trace amounts using a gas plasma to ensure the surface flatness of the first silicon thin film layer near the second through holes 10b.

< Step of Forming Second Conductivity Type Thin Film Layer>

Next, an n-type silicon thin film layer is formed as the second conductivity type thin film layer 4 on exposed portions of the semiconductor substrate in the first through holes 10a, on the first conductive layer 6a and on the first conductivity type thin film layer 3. Specifically, an a-Si:H (n) film or a μc-Si:H (n) film is formed.

Preferably, for example, an a-Si:H (i) film or a μc-Si:H (i) film is formed as the second intrinsic thin film layer 2b that is a semiconductor layer of an intrinsic type (i-type) on exposed portions of the semiconductor substrate in the second through holes 10b, on the first conductive layer 6a and on the first conductivity type thin film layer 3, and thereafter the second conductivity type thin film layer 4 is formed thereon (Fig. 10(g)). The silicon thin film layers formed as the second intrinsic thin film layer 2b and the second conductivity type thin film layer 4 are also referred to hereinafter as a second silicon thin film layer.

Prior to the formation of the second silicon thin film layer as prior to the formation of the first silicon thin film layer, part of the substrate in the second through holes 10b is preferably etched on the order of about several nanometers to tens of nanometers by a hydrogen radical treatment.

The second silicon thin film layer may be formed by applying a technique similar to that for the formation of the first conductivity type thin film layer 3 under similar conditions.

<Step of Forming Second Conductive Layer>

Next, the second conductive layer 6b (a first portion of a second conductive section) is formed in the negative electrode 14. In this case, the formation of the second conductive layer 6b on the second transparent conductive layer 5b after the formation of the second transparent conductive layer 5b on the second conductivity type thin film layer 4 is more preferable (Fig. 10(h)).

The second transparent conductive layer 5b and the second conductive layer 6b may be formed by techniques similar to those for the first transparent conductive layer 5a and the first conductive layer 6a, respectively, under similar conditions. When a sputtering method and an evaporation method are used, it is preferred that a metal mask is provided so as to cover a region except where the second transparent conductive layer 5b and the second conductive layer 6b are to be formed.

<Step of Removing Second Conductivity Type Thin Film Layer>

Next, part of the second silicon thin film layer formed on the first conductive layer 6a in the positive electrode 13 is removed to expose the first conductive layer 6a (Fig. 10(i)). The second silicon thin film layer may be removed by using a sandblast method, a mechanical scribing method, a laser method and the like. In particular, the use of the laser method is preferable because the laser method removes the second silicon thin film layer having a very small thickness with accuracy at a high speed and also reduces damages to the heterojunction to a low level. For the laser method, a YAG laser apparatus may be used. The second silicon thin film layer may be removed, for example, by irradiation with a laser beam having a wavelength of 0.532 μm, a frequency of 1 to 100 kHz, and a pulse width of 10 to 50 nsec under conditions of a power output of 10 to 50 W and an irradiation diameter of 10 to 100 μm. The second conductivity type thin film layer is shown in Fig. 10(i) as removed in positions corresponding to the finger sections 11b. However, the second conductivity type thin film layer may be removed only in a position corresponding to the bus bar section 11 a, rather than in the positions corresponding to the finger sections 11b.

<Step of Forming Textured Structure>

Next, as shown in Fig. 10(j), the textured structure 1a is preferably formed on the front surface (the light receiving surface) side of the semiconductor substrate 1 by an etching method.

A wet etching method using an alkaline aqueous solution and a dry etching method using an etching gas may be used as a method of forming the textured structure 1a. For the wet etching method, it is preferable to perform the method prior to the formation of the above-mentioned thin film layers.

The use of the dry etching method allows the formation of the minute textured structure 1a only on a treatment surface side (the light receiving surface side). For a BC type solar cell device such as the solar cell device 20A according to the present embodiment, the use of the dry etching method for the formation of the textured structure only on the light receiving surface side of the semiconductor substrate 1 needs not the formation of a textured structure in an area where n/p or p/p+ junctions are to be formed. This provides a solar cell device having better characteristics such as a low current density (approximately equal to the dark current density) of a diode current resulting from these junctions and a low current density of a diode current resulting from a conductive layer interface. When the wet etching method is used, the etching may be performed after the formation of a mask on the back surface side.

The dry etching method includes a variety of techniques. In particular, the use of a RIE method (Reactive Ion Etching method) enables the minute textured structure 1a capable of reducing the optical reflectance to an extremely low level over a wide wavelength range to be formed over a wide area in a short time.

It is not essential to form the textured structure 1a in this stage. The textured structure 1a may be formed, for example, prior to the formation of the first silicon thin film layer or after the formation of the second conductive layer 6b. When the wet etching method is used, the textured structure 1a may be formed immediately following the process of removing the damaged layer in the surface part of the substrate as mentioned earlier.

<Step of Forming Passivation Layer and Anti-Reflection Layer>

Next, as shown in Fig. 10(k), the passivation layer 8 and the anti-reflection layer 9 are formed on the light receiving surface side of the semiconductor substrate 1.

The passivation layer 8 may be formed by a method similar to that for the insulation layer 7. The substrate surface on which the passivation layer 8 is to be formed may be treated with a cleaning gas, as required. The process of etching the surface on the substrate in trace amounts, for example, using a gas plasma such as $CF_4$, $SF_6$ and the like cleans the surface well.

The anti-reflection layer 9 may be formed by a PECVD method, an evaporation method, a sputtering method and the like. For the formation of the anti-reflection layer 9, a film deposition temperature is preferably not higher than 400 °C, more preferably not higher than 300 °C . The passivation layer 8 may have also the function as the anti-reflection layer 9. In this case, the film thickness d and the reflectance n of the passivation layer 8 are adjusted in accordance with the following equation:

$$d = (1/4) * (\lambda / n)$$

<Step of Forming Output Extraction Electrodes>

Next, as shown in Fig. 10(1), the first electrode 11 (a second portion of the first conductive section) and the second electrode 12 (a second portion of the second conductive section) serving as the output extraction electrodes are formed.

These output extraction electrodes are formed by forming an electrode pattern, which is made of a metal paste prepared by mixing a powder of metal and an organic component together, by a coating method such as a printing method, and thereafter firing the electrode pattern. At this time, a resin binder that hardens at a temperature close to 200 °C is used to reduce damages to the silicon thin film layer. One or more resins selected from the group consisting of epoxy resin, phenolic resin, urethane resin, and polyester resin may be used as such a resin binder. The firing may be performed for approximately one hour.

<Step of Forming Solder>

A solder region may be further formed on the first electrode 11 and the second electrode 12 by a solder dipping process, as required.

The solar cell device 20A is produced by carrying out the procedure as mentioned above. According to such a manufacturing method, the use of a method of forming a thin film such as a Cat-PECVD method for the formation of the first and second silicon thin film layers at an extremely low temperature on the order of about 200 °C enables the High-low heterojunction with extremely high quality to be formed between the semiconductor substrate 1 and the first conductivity type thin film layer 3, and enables the heterojunction with extremely high quality to be formed between the semiconductor substrate 1 and the second conductivity type thin film layer 4. This method is capable of forming a BC type solar cell device without using a high-temperature process at 500 °C or higher to provide savings of energy for the manufacturing steps.

Also, in the manufacturing method according to the present embodiment, only the formation of the second through holes 10b after the formation of the first silicon thin film layer subsequent to the formation of the first through holes 10a allows the formation of the second silicon thin film layer of the opposite conductivity type. This eliminates the need for complicated processes such as the formation of a mask and the removal of the first silicon thin film layer by wet etching before the formation of the second silicon thin film layer. In addition, the formation of a mask and the wet etching are not essential for the exposure of the first conductive layer 6a. In other words, the solar cell device of the BC type and providing high conversion efficiency by having the local heterostructure such that the junctions are formed locally only where the through holes are formed is produced by an extremely simplified device production process.

Additionally, the wet etching is not essential in the manufacturing method according to the present embodiment. This significantly reduces the amount of liquid chemical for use in the manufacturing process to accordingly reduce environmental loads and manufacturing costs.

<<Solar Cell Module>>

A solar cell module is constructed by connecting a plurality of solar cell devices in series and in parallel.

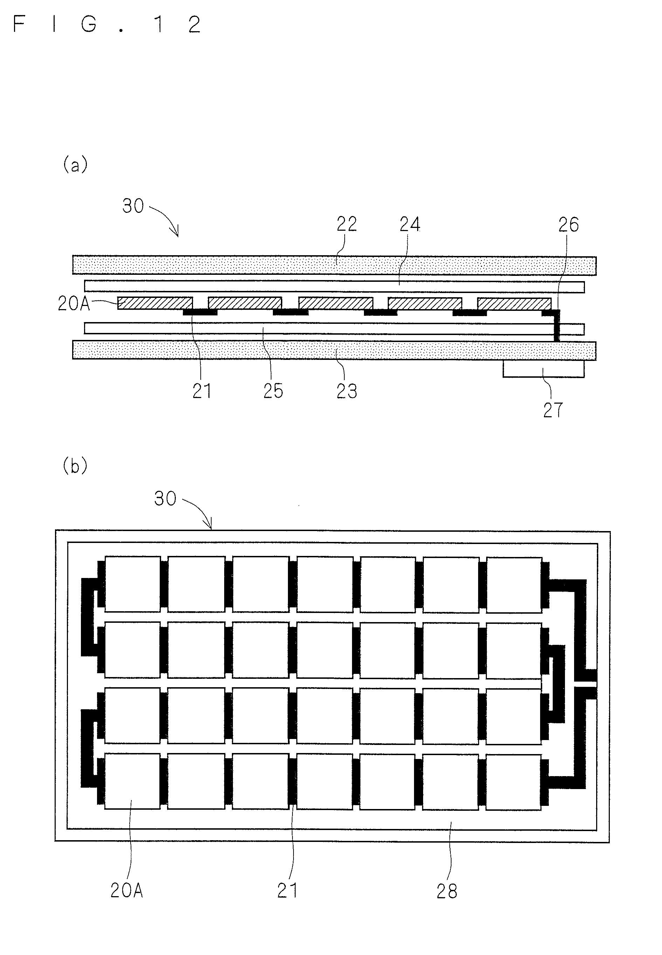

As shown in Fig. 12(a), a solar cell module 30 principally includes a light-permeable member 22 made of, for example, glass, a front side filler 24 made of light-permeable ethylene-vinyl acetate copolymers (EVA) and the like, a plurality of solar cell devices 20A configured by connecting the first electrodes 11 and the second electrodes 12 of adjacent ones of the solar cell devices in an alternating manner with wiring 21, a back side filler 25 made of EVA and the like, and a back side protection material 23 configured such that polyethylene terephthalate (PET) or metal foil are held between polyvinyl fluoride (PVF). Preferably, the front side filler 24 and the back side filler 25 contain an acid acceptor. Examples of the acid acceptor usable herein include metallic oxides such as magnesium oxide (MgO) and lead oxide ($Pb_3O_4$), metallic hydroxides such as magnesium hydroxide (Mg(OH)$_2$) and calcium hydroxide (Ca(OH)$_2$), metal carbonates such as calcium carbonate ($CaCO_3$), and mixtures thereof. The wiring 21 configured such that the entire surface of copper foil having a thickness on the order of about 0.1 to 0.2 mm and a width on the order of about 2 mm is coated with a solder material are used for the adjacent solar cell devices 20A.

An electrode of one end in each of the first and last ones of the solar cell devices 20A connected in series is connected to a terminal box 27 serving as an output extraction section through an output extraction line 26. As shown in Fig. 12(b), the solar cell module 30 according to the present embodiment includes a frame 28 made of aluminum and the like.

The solar cell module 30 according to the present embodiment is constructed using the solar cell devices 20A. This provides photoelectric conversion devices and a photoelectric conversion module that are lower in costs and higher in efficiency than earlier.

<Modifications of First Embodiment>

The procedure for the production of the solar cell device 20A is not limited to that shown in Fig. 10.

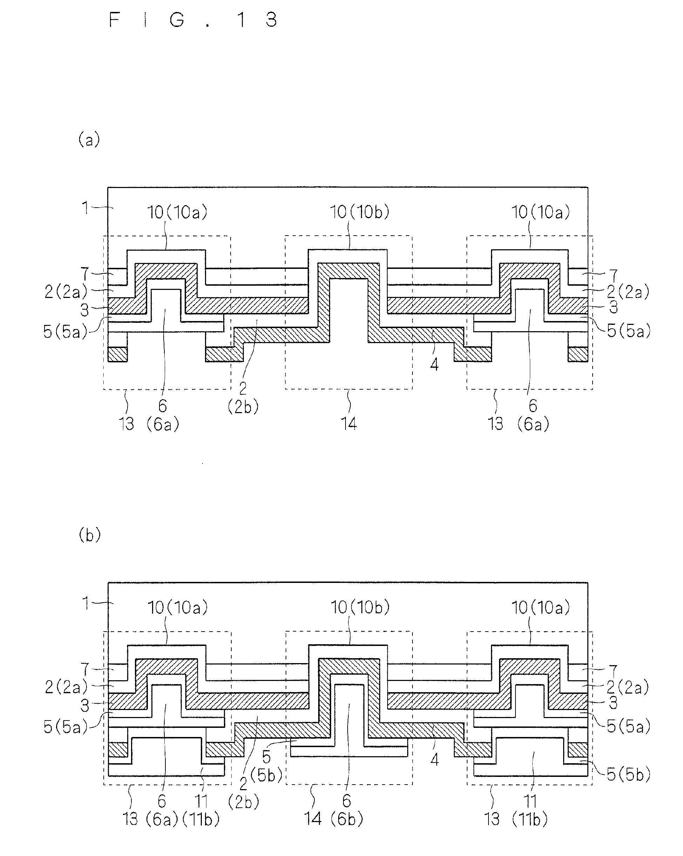

In the procedure shown in Fig. 10, after the second transparent conductive layer 5b and the second conductive layer 6b are formed (Fig. 10(h)), the second silicon thin film layer (the second intrinsic thin film layer 2b and the second conductivity type thin film layer 4) is removed in the position where the first transparent conductive layer 5a and the first conductive layer 6a are formed (Fig. 10(i)). Instead, as shown in Fig. 13(a), the second silicon thin film layer may be removed prior to the formation of the second transparent conductive layer 5b and the second conductive layer 6b. In this case, as shown in Fig. 13(b), the first electrode 11 may be formed on the first conductive layer 6a at the same time as the formation of the second conductive layer 6b.

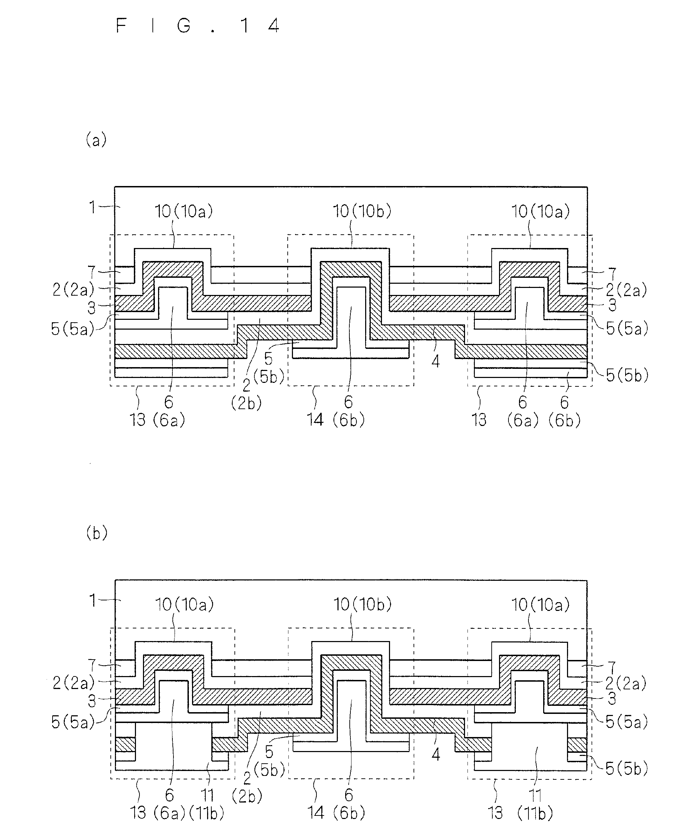

Alternatively, as shown in Fig. 14(a), the second transparent conductive layer 5b and the second conductive layer 6b may be formed without removing the second silicon thin film layer (the second intrinsic thin film layer 2b and the second conductivity type thin film layer 4) in the position where the first transparent conductive layer 5a and the first conductive layer 6a are formed (Fig. 10(i)), whereby the second transparent conductive layer 5b and the second conductive layer 6b are temporarily formed on the second conductivity type thin film layer 4 provided not only in the negative electrode 14 but also in the positive electrode 13. Following this, the first electrode 11 is connected to the first conductive layer 6a by providing electrical contact between the second conductive layer 6b formed in the positive electrode 13 and the first conductive layer 6a, as shown in Fig. 14(b). Specifically, the second conductive layer 6b in the positive electrode 13 is heated to melt, thereby penetrating the second silicon thin film layer and the second transparent conductive layer 5b, which in turn establishes an electrical short circuit between the first conductive layer 6a and the second conductive layer 6a.

It is preferred that the melting by heating is done by laser irradiation. When a YAG laser apparatus is used, the electrical short circuit is established between the first conductive layer 6a and the second conductive layer 6b by irradiation with, for example, a pulsed laser beam having a wavelength of 1.064 $\mu$m and a pulse width of 125 nsec at a power density on the order of about 0.0001 to 0.01 J per pulse so as to provide an irradiation diameter of 40 $\mu$m.

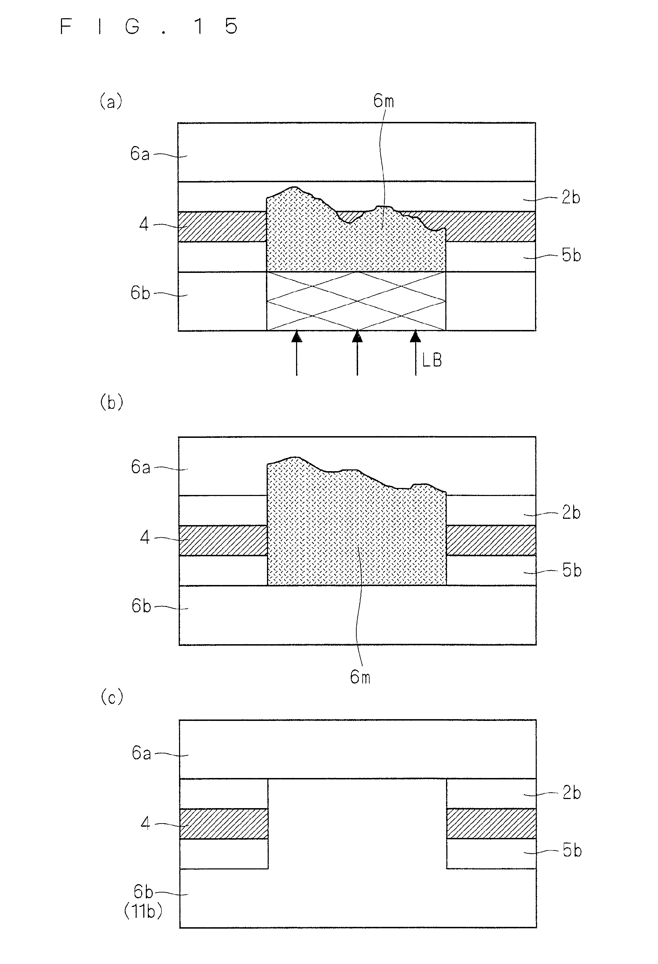

When the metal for the second conductive layer 6b is irradiated with the laser beam LB to melt, the second transparent conductive layer 5b, the second conductivity type thin film layer 4 and the second intrinsic thin film layer 2b which are very thin are eroded sequentially and easily by molten metal 6m, as shown in Fig. 15(a). Further, the molten metal 6m also melts a partial region of the first conductive layer 6a, as shown in Fig. 15(b).

Then, after the completion of the laser irradiation, the molten metal 6m is solidified by cooling. As a result, as shown in Fig. 15(c), contact is made between the first conductive layer 6a and the second conductive layer 6b, whereby the first electrode 11 is connected to the first conductive layer 6a.

The thickness of the second conductive layer 6b is on the order of about 0.1 to 3 $\mu$m as mentioned above, and is generally sufficiently large as compared with the sum of the thicknesses of the second transparent conductive layer 5, the second intrinsic thin film layer 2b and the second conductivity type thin film layer 4. For this reason, the thickness of the second conductive layer 6b itself after the molten metal 6m is solidified by cooling may be considered to be approximately equal to that before the melting by heating.

Also, the process of forming the textured structure on the light receiving surface side of the semiconductor substrate 1 and the process of forming the passivation film and the anti-reflection film, both of which have been performed after the processes of forming the thin film layers and the conductive layers on the back surface side of the semiconductor substrate in the procedure shown in Fig. 10, may be performed prior to these, and thereafter the thin film layers and the conductive layers may be formed on the back surface side.

In the configuration shown in Figs. 4 and 5, the first conductive layer 6a and the second conductive layer 6b are in the form of lines that connect the first through holes 10a to each other or connect the second through holes 10b to each other in the positive electrode 13 or in the negative electrode 14. Instead, the first conductive layer 6a and the second conductive layer 6b may be provided only in each of the individual through holes 10, and an additional conductive layer may be provided by coating or firing a metal paste so as to connect the first conductive layers 6a provided in the respective through holes 10 to each other and to connect the second conductive layers 6b provided in the respective through holes 10 to each other. In such a case, the first conductive layers 6a and the second conductive layers 6b may be used as external electrodes without providing the first electrode 11 and the second electrode 12.

Also, a solder region not shown may be formed, as required, on the first electrode 11 and the second electrode 12.

<Second Embodiment>

«Structure of Solar Cell Device»

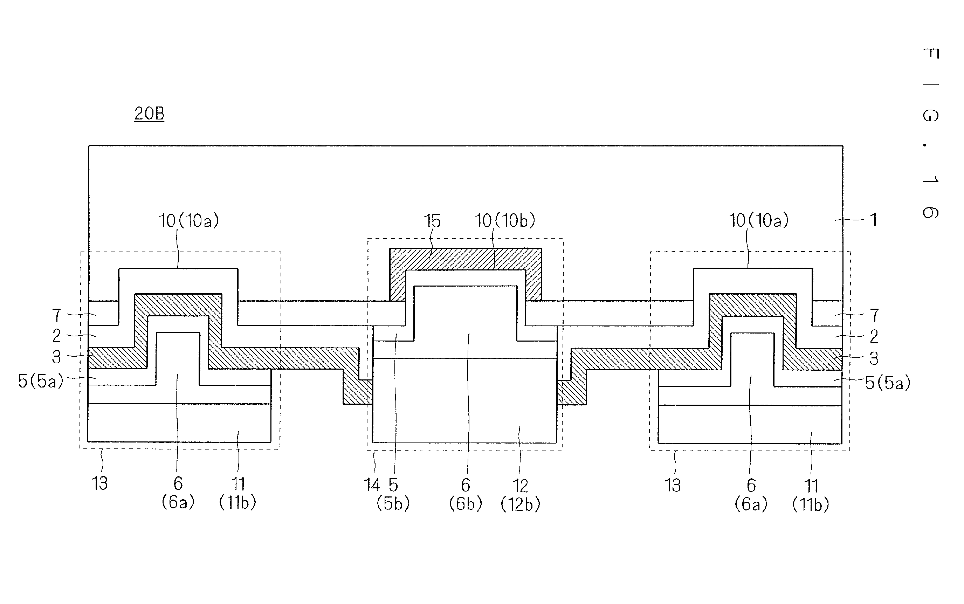

A solar cell device 20B according to a second embodiment of the present invention will be described with reference to Fig. 16. Components in the solar cell device 20B that are similar in function and effect to those in the solar cell device 20A according to the first embodiment are designated by like reference numerals and characters, and will not be described.

The solar cell device 20B is a BC type solar cell device including a positive electrode and a negative electrode on the back surface side thereof. In the present embodiment, the textured structure 1a, the passivation layer 8 and the anti-reflection layer 9 are not shown for the purpose of simplicity of illustration, but may be provided on the light receiving surface side also in the solar cell device 20B.

In such a solar cell device 20B, the intrinsic thin film layer 2, the first conductivity type thin film layer 3, the transparent conductive layer 5 (including the first transparent conductive layer 5a and the second transparent conductive layer 5b), the conductive layer 6 (including the first conductive layer 6a and the second conductive layer 6b), the insulation layer 7, and a conductive diffusion layer 15 are principally provided on the back surface side of the semiconductor substrate 1.

Also in the solar cell device 20B, the insulation layer 7 is provided with the plurality of through holes 10. The through holes 10 are similar in shape and arrangement to those of the first embodiment. Recessed portions in the back surface of the semiconductor substrate 1 in the solar cell device 20B shown in Fig. 16 are not essential. Also in the present embodiment, the through holes 10 include the first through holes 10a disposed along the finger sections 11b, and the second through holes 10b disposed along the finger sections 12b.

In the solar cell device 20B, as shown in Fig.

16, the intrinsic thin film layer 2 and the first conductivity type thin film layer 3 are stacked on exposed portions of the semiconductor substrate 1 in the first through holes 10a, and on the insulation layer 7 (except near the second through holes 10b). In the positive electrode 13, the first transparent conductive layer 5a and the first conductive layer 6a are further stacked on the first conductivity type thin film layer 3. It should be noted that the intrinsic thin film layer 2 and the first transparent conductive layer 5a are not essential. The first conductivity type thin film layer 3 may be formed directly in the first through holes 10a and on the insulation layer 7. In the positive electrode 13, the first conductive layer 6a may be formed directly on the first conductivity type thin film layer 3.

On the other hand, the second transparent conductive layer 5b and the second conductive layer 6b are stacked on the inner surfaces of the second through holes 10b and on portions of the insulation layer 7 formed around the second through holes 10b. It should be noted that the second transparent conductive layer 5b is not essential, but the second conductive layer 6b may be formed directly.

In the second through holes 10b, the conductive diffusion layer 15 of the n-type conductivity type is further formed near the surface of the semiconductor substrate 1 (near the junction interface with the second transparent conductive layer 5b).

The conductive diffusion layer 15 is a semiconductor region of a conductivity type opposite to that of the semiconductor substrate 1. The conductive diffusion layer 15 is formed by diffusing a predetermined dopant therein so as to be of the n-type when the semiconductor substrate 1 is of the p-type and to be of the p-type when the semiconductor substrate 1 is of the n-type.

In the solar cell device 20B having such a configuration, the first conductivity type thin film layer 3 that forms a heterojunction with the semiconductor substrate 1 has an extremely high resistance in a direction substantially parallel to the back surface of the semiconductor substrate 1. This provides electrical isolation between the positive electrode 13 and the negative electrode 14.

In the solar cell device 20B, a p/i/p$^+$ junction region (a High-Low junction region) such that the semiconductor substrate 1 and the first conductivity type thin film layer 3 sandwich the first intrinsic thin film layer 2a therebetween is formed only in each of the first through holes 10a. A PN junction region between a bulk region of the semiconductor substrate 1 of the p-type and the conductive diffusion layer 15 of the n-type conductivity type is formed only in each of the second through holes 10b. Additionally, since the plurality of first through holes 10a and the plurality of second through holes 10b are in the form of dots, the junction regions are also in the form of dots, as in the first embodiment. The solar cell device 20B accordingly has a reduced dark current to provide a greater Voc.

Also in the solar cell device 20B as in the solar cell device 20A according to the first embodiment, the insulation layer 7 is present between the High-Low junction regions formed in the first through holes 10a and the PN junction regions formed in the second through holes 10b to achieve a structure in which the High-Low junction regions and the PN junction regions are spaced apart from each other. This reduces a leakage current. Further, the first conductivity type thin film layer 3 is provided on the insulation layer 7 except where the through holes 10 are provided. Such a structure produces the effect of reducing the recombination of minority carriers.

<<Method of Manufacturing Solar Cell Device»

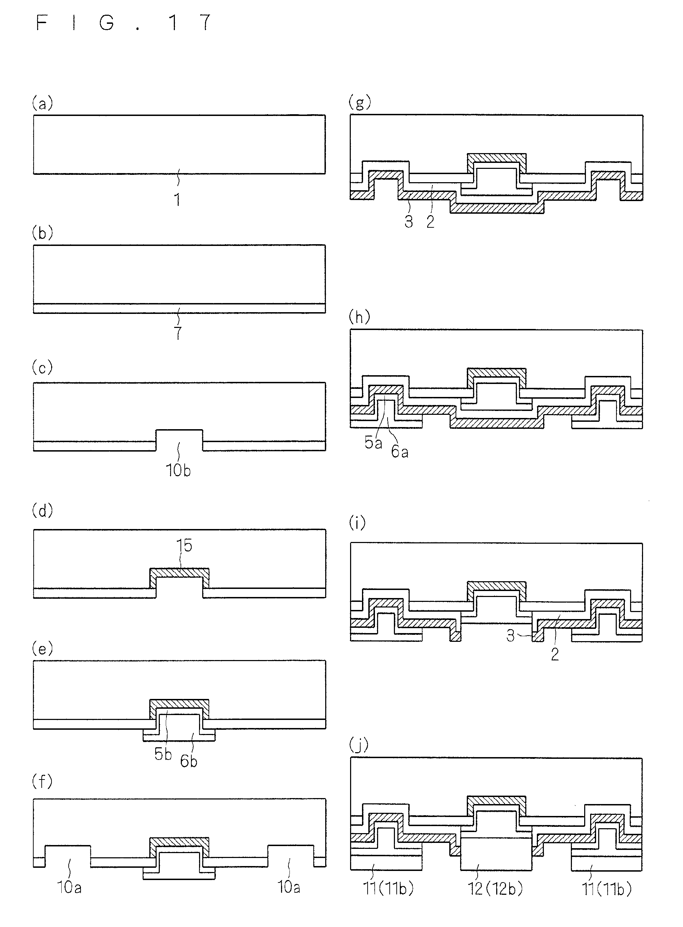

A method of manufacturing the solar cell device 20B will be described with reference to Fig. 17. The steps which are common to the method of manufacturing the solar cell device 20A according to the first embodiment will not be described in detail. In the present embodiment, an instance where a crystalline silicon substrate of the p-type conductivity type is used as the semiconductor substrate 1 will be described by way of example.

First, the semiconductor substrate 1 of the p-type conductivity type is prepared (Fig. 17(a)). Then, the insulation layer 7 is formed on the first main surface side of the semiconductor substrate 1 (Fig. 17(b)), as in the first embodiment.

Next, the second through holes 10b are formed in the insulation layer 7 in the present embodiment. The second through holes 10b are provided in positions (in the second region) where the junction region between the semiconductor substrate 1 and the conductive diffusion layer 15 to be formed later is to be formed (Fig. 17 (c)). Examples of the method of forming the second through holes 10b used herein include a sandblast method, a mechanical scribing method, a laser method and the like.

After the second through holes 10b are formed, the conductive diffusion layer 15 is formed on exposed portions of the semiconductor substrate 1 in the second through holes 10b (Fig. 17(d)). A preferred example of the formation of the conductive diffusion layer 15 employs a vapor phase diffusion method as follows: a mask is formed on the semiconductor substrate 1 except where the conductive diffusion layer 15 is to be formed is placed in a predetermined reactor vessel after the formation of the second through holes 10b, and then phosphorus oxychloride (POCl$_3$) serving as a diffusion source is caused to flow while the semiconductor substrate 1 is heated, thereby thermally diffusing phosphorus (P) that is an n-type dopant to the surface of the semiconductor substrate 1. The PN junction in each of the second through holes 10b is formed by the formation of the conductive diffusion layer 15.

After the conductive diffusion layer 15 is formed, the second conductive layer 6b is subsequently formed in the negative electrode 14 so as to fill the second through holes 10b. In this case, the second conductive layer 6b is more preferably formed after the second transparent conductive layer 5b is formed (Fig. 17(e)). The second transparent conductive layer 5b and the second conductive layer 6b are formed by a technique similar to that in the first embodiment under similar conditions.

After the second conductive layer 6b is formed, the first through holes 10a are subsequently formed by providing a plurality of through holes in the insulation layer 7. The first through holes 10a are provided in positions (in the first region) where the junction region between the semiconductor substrate 1 and the first conductivity type thin film layer 3 to be formed later is to be formed (Fig. 17(f)). Examples of the method of forming the first through holes 10a used herein include a sandblast method, a mechanical scribing method, a laser method and the like, as in the first embodiment.

Next, a p-type silicon thin film layer is formed as the first conductivity type thin film layer 3 on the inner surfaces of the first through holes 10a, on exposed portions of the semiconductor substrate 1 in the first through holes 10a, on the insulation layer 7 and on the second conductive layer 6b. This forms a High-low heterojunction in each of the first through holes 10a. Preferably, the first conductivity type thin film layer 3 is formed after the intrinsic thin film layer 2 that is a semiconductor layer of the intrinsic type (i-type) is formed (Fig. 17(g)). The intrinsic thin film layer 2 and the first conductivity type thin film layer 3 are also referred to simply as a silicon thin film layer hereinafter. The silicon thin film layer is formed by a technique similar to that for the first silicon thin film layer in the first embodiment.

Next, the first conductive layer 6a is formed in the positive electrode 13. In this case, the formation of the first conductive layer 6a on the first transparent conductive layer 5a after the formation of the first transparent conductive layer 5a on the first conductivity type thin film layer 3 improves optical reflectance, and is hence preferable (Fig. 17(h)).

After the first conductive layer 6a is formed, part of the silicon thin film layer formed on the second conductive layer 6b in the negative electrode 14 is removed to expose the second conductive layer 6b (Fig. 17(i)). Such a silicon film layer may be removed by using a sandblast method, a mechanical scribing method, a laser method and the like. In this case, the silicon thin film layer is removed in positions corresponding to the finger sections 12b. However, the silicon thin film layer may be removed only in a position corresponding to the bus bar section 12a, rather than in the positions corresponding to the finger sections 12b.

Finally, the first electrode 11 and the second electrode 12 serving as the output extraction electrodes are formed by a technique similar to that in the first embodiment (Fig. 17(j)).

The solar cell device 20B is produced by carrying out the procedure as mentioned above. Also in such a procedure, the use of a method of forming a thin film such as a Cat-PECVD method for the formation of the silicon thin film layer enables the High-low heterojunction with extremely high quality to be formed between the semiconductor substrate 1 and the first conductivity type thin film layer 3 at an extremely low temperature on the order of 200 °C. This provides savings of energy for the manufacturing steps.

In the manufacturing method according to the present embodiment, only the formation of the first through holes 10a after the formation of the conductive diffusion layer 15 subsequent to the formation of the second through holes 10b allows the formation of the silicon thin film layer without the need for complicated processes such as the formation of a mask and the removal of the first silicon thin film layer by wet etching. In addition, the formation of a mask and the wet etching are not essential during the removal of the silicon thin film layer for the exposure of the second conductive layer 6b. In other words, the solar cell device of the BC type and providing high conversion efficiency by having the local heterostructure such that the junctions are formed locally only where the through holes are formed is produced by an extremely simplified device production process.

The wet etching is not essential also in the manufacturing method according to the present embodiment. This significantly reduces the amount of liquid chemical for use in the manufacturing process to accordingly reduce environmental loads and manufacturing costs, as in the manufacturing method according to the first embodiment.

<Third Embodiment>

<<Structure of Solar Cell Device>>

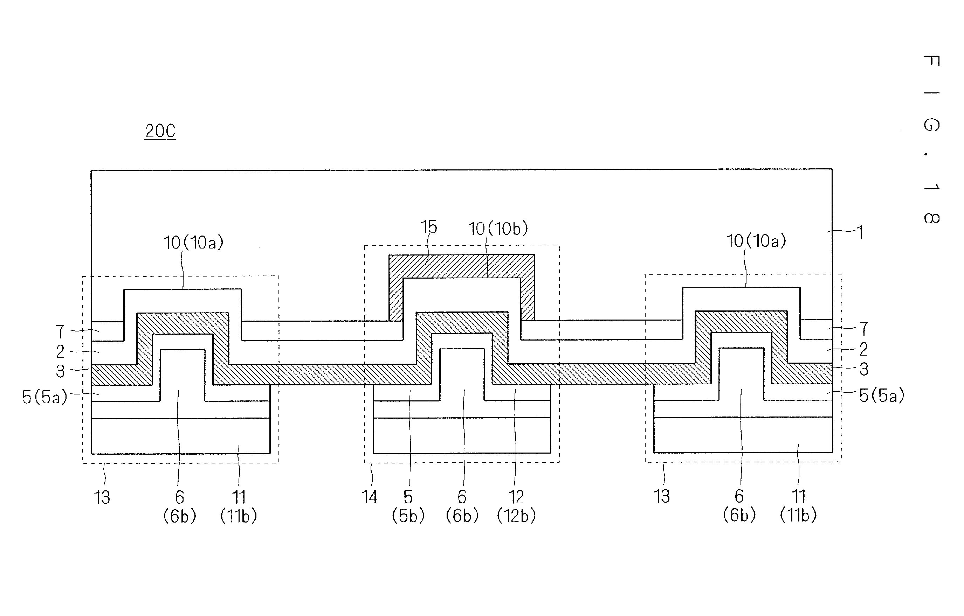

A solar cell device 20C according to a third embodiment of the present invention will be described with reference to Fig. 18. Components in the solar cell device 20C that are similar in function and effect to those in the solar cell device 20A according to the first embodiment and in the solar cell device 20B according to the second embodiment are designated by like reference numerals and characters, and will not be described.

The solar cell device 20C is a BC type solar cell device including a positive electrode and a negative electrode on the back surface side thereof. In the present embodiment, the textured structure 1a, the passivation layer 8 and the anti-reflection layer 9 are not shown for the purpose of simplicity of illustration, but may be provided on the light receiving surface side also in the solar cell device 20C.

In such a solar cell device 20C as in the solar cell device 20B according to the second embodiment, the intrinsic thin film layer 2, the first conductivity type thin film layer 3, the transparent conductive layer 5 (including the first transparent conductive layer 5a and the second transparent conductive layer 5b), the conductive layer 6 (including the first conductive layer 6a and the second conductive layer 6b), the insulation layer 7, and the conductive diffusion layer 15 are principally provided on the back surface side of the semiconductor substrate 1.

Also in the solar cell device 20C, the insulation layer 7 is provided with the plurality of through holes 10. The through holes 10 are similar in shape and arrangement to those of the first and second embodiments. Recessed portions in the back surface of the semiconductor substrate 1 in the solar cell device 20C shown in Fig. 18 are not essential. Also in the present embodiment, the through holes 10 include the first through holes 10a disposed along the finger sections 11b, and the second through holes 10b disposed along the finger sections 12b.

With reference to Fig. 18, the solar cell device 20C differs from the solar cell device 20B according to the second embodiment in that the intrinsic thin film layer 2 and the first conductivity type thin film layer 3 are stacked also on the second through holes 10b.

In the positive electrode 13, the first transparent conductive layer 5a and the first conductive layer 6a are further stacked on the first conductivity type thin film layer 3. It should be noted that the intrinsic thin film layer 2 and the first transparent conductive layer 5a are not essential. The first conductivity type thin film layer 3 may be formed directly in the first through holes 10a and on the insulation layer 7. In the positive electrode 13, the first conductive layer 6a may be formed directly on the first conductivity type thin film layer 3.

In the negative electrode 14, the second transparent conductive layer 5b and the second conductive layer 6b are stacked on the first conductivity type thin film layer 3 formed as mentioned above. It should be noted that the second transparent conductive layer 5b is not essential, but the second conductive layer 6b may be formed directly.

In the negative electrode 14 for the solar cell device 20C, the first conductive thin film layer 3 of the p-type conductivity type is present between the conductive diffusion layer 15 of the n-type conductivity type and the second conductive layer 6b. However, since the first conductive thin film layer 3 has a thickness on the order of about 5 to 50 nm, carriers moving from the semiconductor substrate 1 toward the second conductive layer 6b tunnel through the first conductive thin film layer 3, and are extracted at the second electrode 12.

In the solar cell device 20C having such a configuration, the first conductivity type thin film layer 3 that forms a heterojunction with the semiconductor substrate 1 has an extremely high resistance in a direction within the layer. This provides electrical isolation between the positive electrode 13 and the negative electrode 14.

In the solar cell device 20C, a p/i/p+ junction region (a High-Low junction region) such that the semiconductor substrate 1 and the first conductivity type thin film layer 3 sandwich the first intrinsic thin film layer 2a therebetween is formed only in each of the first through holes 10a. A PN junction region between a bulk region of the semiconductor substrate 1 of the p-type and the conductive diffusion layer 15 of the n-type conductivity type is formed only in each of the second through holes 10b. Additionally, since the plurality of first through holes 10a and the plurality of second through holes 10b are in the form of dots, the junction regions are also in the form of dots. The solar cell device 20C accordingly has a reduced dark current to provide a greater Voc.

Also in the solar cell device 20C as in the solar cell device 20A and the solar cell device 20C, the insulation layer 7 is present between the High-Low junction regions formed in the first through holes 10a and the PN junction regions formed in the second through holes 10b to achieve a structure in which the High-Low junction regions and the PN junction regions are spaced apart from each other. This reduces a leakage current. Further, the first conductivity type thin film layer 3 is provided on the insulation layer 7 except where the through holes 10 are provided. Such a structure produces the effect of reducing the recombination of minority carriers.

<<Method of Manufacturing Solar Cell Device>>

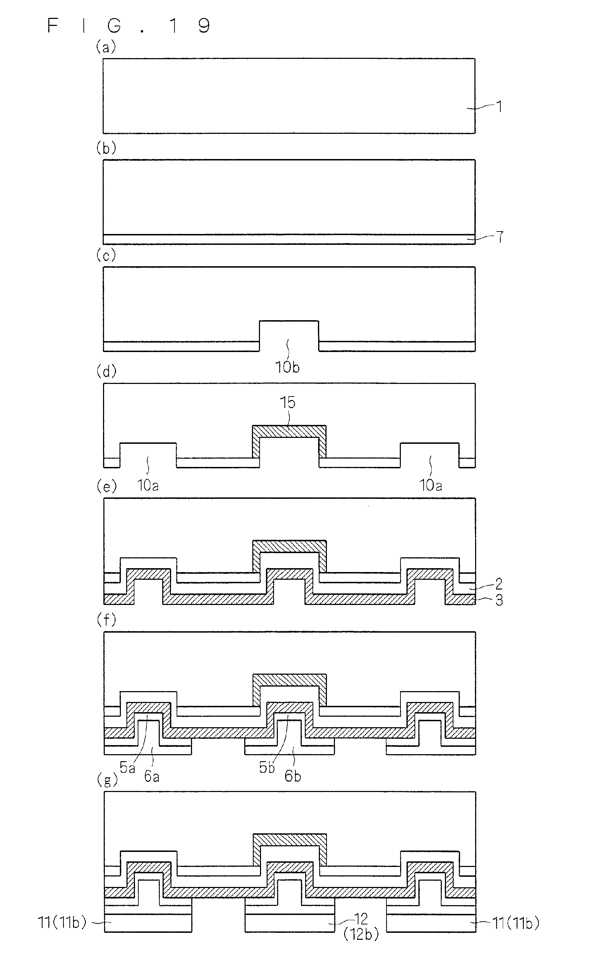

A method of manufacturing the solar cell device 20C will be described with reference to Fig. 19. The steps which are common to the methods of manufacturing the solar cell device 20A according to the first embodiment and the solar cell device 20B according to the second embodiment will not be described in detail. In the present embodiment, an instance where a crystalline silicon substrate of the p-type conductivity type is used as the semiconductor substrate 1 will be described by way of example.

First, the semiconductor substrate 1 of the p-type conductivity type is prepared (Fig. 19(a)). The process of forming the insulation layer 7 (Fig. 19(b)), the process of forming the second through holes 10b (Fig. 19(c)), and the process of forming the conductive diffusion layer 15 (Fig. 19(d)) are performed in a manner similar to that in the second embodiment.

After the conductive diffusion layer 15 is formed, the first through holes 10a are formed in the present embodiment by providing a plurality of through holes in the insulation layer 7. The first through holes 10a are provided in positions (in the first region) where the junction region between the semiconductor substrate 1 and the first conductivity type thin film layer 3 to be formed later is to be formed (Fig. 19(d)).

Next, a p-type silicon thin film layer is formed as the first conductivity type thin film layer 3 on the inner surfaces of the first through holes 10a, on exposed portions of the semiconductor substrate 1 in the first through holes 10a, on the insulation layer 7, and on the second through holes 10b (i.e., over the entire surface on the back surface side). This forms a High-low heterojunction in each of the first through holes 10a. Preferably, the first conductivity type thin film layer 3 is formed after the intrinsic thin film layer 2 that is a semiconductor layer of the intrinsic type (i-type) is formed (Fig. 19(e)). The intrinsic thin film layer 2 and the first conductivity type thin film layer 3 are also referred to simply as a silicon thin film layer in the present embodiment. The silicon thin film layer is formed by a technique similar to that for the silicon thin film layer in the second embodiment.

Subsequently, the first conductive layer 6a is formed in the positive electrode 13 so as to fill the first through holes 10a, and the second conductive layer 6b is formed in the negative electrode 14 so as to fill the second through holes 10b. In this case, the first conductive layer 6a and the second conductive layer 6b are more preferably formed after the first transparent conductive layer 5a and the second transparent conductive layer 5b are formed in the positive electrode 13 and the negative electrode 14, respectively (Fig. 19(f)). The transparent conductive layer 5 (including the first transparent conductive layer 5a and the second transparent conductive layer 5b) and the conductive layer 6 (including the first conductive layer 6a and the second conductive layer 6b) are formed by techniques similar to those in the first and second embodiments under similar conditions.

After the first conductive layer 6a and the second conductive layer 6b are formed, the first electrode 11 and the second electrode 12 serving as the output extraction electrodes are finally formed by a technique similar to that in the first embodiment (Fig. 19(g)).

The solar cell device 20C is produced by carrying out the procedure as mentioned above. The use of a method of forming a thin film such as a Cat-PECVD method for the formation of the silicon thin film layer enables the High-low heterojunction with extremely high quality to be formed between the semiconductor substrate 1 and the first conductivity type thin film layer 3 at an extremely low temperature on the order of about 200°C. This provides savings of energy for the manufacturing steps.

In the manufacturing method according to the present embodiment, only the formation of the first through holes 10a after the formation of the conductive diffusion layer 15 subsequent to the formation of the second through holes 10b allows the formation of the silicon thin film layer without the need for complicated processes such as the formation of a mask and the removal of the first silicon thin film layer by wet etching. In addition, the step of removing the silicon thin film layer is not required because the second conductive layer 6b is not exposed. In other words, the solar cell device of the BC type and providing high conversion efficiency by having the local heterostructure such that the junctions are formed locally only where the through holes are formed is produced by an extremely simplified device production process.

The wet etching is not essential also in the manufacturing method according to the present embodiment. This significantly reduces the amount of liquid chemical for use in the manufacturing process to accordingly reduce environmental loads and manufacturing costs, as in the manufacturing methods according to the first and second embodiments.

<Other Modifications>

The present invention is not limited to the above-mentioned embodiments and the modifications thereof, but various variations, improvements and the like may be made without departing from the spirit and scope of the present invention.

For example, the instance where the semiconductor substrate of the p-type conductivity type is used is described in the above-mentioned embodiments. Instead, a semiconductor substrate of the n-type conductivity type may be used. In this case, a solar cell device that produces similar functions and effects is provided by performing the steps similar to those of the above-mentioned embodiments only when the polarities of the respective layers are reversed.

Also, silicon is taken as an example of the materials for the semiconductor substrate 1 and the thin film layers in the above-mentioned embodiments. The materials of the semiconductor substrate 1 and the thin film layers according to the present invention are not limited to silicon. The present invention is applicable when other semiconductor materials such as SiC, SiGe and Ge are used.

While the invention has been shown and described in detail, the foregoing description is in all aspects illustrative and not restrictive. It is therefore understood that numerous modifications and variations can be devised without departing from the scope of the invention.

**Claims**

1. A solar cell device comprising:

   a semiconductor substrate of a first conductivity type comprising a light receiving surface and a back surface opposite said light receiving surface;
   an insulation layer formed on said back surface side of said semiconductor substrate and comprising at least one first through hole and at least one second through hole;
   a first layer of the first conductivity type formed on said insulation layer and formed on part of said semiconductor substrate in said at least one first through hole; and
   a second layer of an opposite conductivity type formed on said first layer and formed on part of said semiconductor substrate in said at least one second through hole.

2. The solar cell device according to claim 1,

   wherein said at least one first through hole comprises a plurality of first through holes, and said at least one second through hole comprises a plurality of second through holes,

   said solar cell device further comprising:
   a plurality of first junction regions formed in said plurality of first through holes, respectively, and formed at an interface between said semiconductor substrate and said first layer;
   a first conductive section for connecting said plurality of first junction regions to each other;
   a plurality of second junction regions formed in said plurality of second through holes, respectively, and formed at an interface between said semiconductor substrate and said second layer; and
   a second conductive section for connecting said plurality of second junction regions to each other.

3. A solar cell device comprising:

   a semiconductor substrate of a first conductivity type comprising a light receiving surface and a back surface opposite said light receiving surface;
   an insulation layer formed on said back surface side of said semiconductor substrate and comprising at least one first through hole and at least one second through hole;
   a first layer of the first conductivity type formed on said insulation layer and formed on part of said semiconductor substrate in said at least one first through hole; and
   a diffusion layer of an opposite conductivity type formed near part of said back surface of said semiconductor substrate in said at least one second through hole.

4. The solar cell device according to claim 3,

   wherein said at least one first through hole comprises a plurality of first through holes, and said at least one second through hole comprises a plurality of second through holes,
   said solar cell device further comprising:
   a plurality of first junction regions formed in said plurality of first through holes, respectively, and formed at an interface between said semiconductor substrate and said first layer;
   a first conductive section for connecting said plurality of first junction regions to each other;
   a plurality of second junction regions formed in said plurality of second through holes, respectively, and formed at an interface between said semiconductor substrate and said diffusion layer; and
   a second conductive section for connecting said plurality of second junction regions to each other.

5. The solar cell device according to claim 3 or 4,

wherein said first layer is formed in common in said at least one first through hole and in said at least one second through hole.

6. The solar cell device according to claim 2 or 4, wherein each of said first conductive section and said second conductive section comprises a comb-shaped electrode with a plurality of electrode fingers on said back surface side of said semiconductor substrate, wherein said first through holes are arranged along said electrode fingers of said first conductive section, and wherein said second through holes are arranged along said electrode fingers of said second conductive section.

7. The solar cell device according to any one of claims 1 to 6, wherein said semiconductor substrate comprises recessed portions in positions where said at least one first through hole and said at least one second through hole in said insulation layer are formed as seen in plan perspective.

8. A method of manufacturing a solar cell device, comprising:

preparing a semiconductor substrate of a first conductivity type comprising a light receiving surface and a back surface opposite said light receiving surface;
forming an insulation layer on said back surface side of said semiconductor substrate;
removing a first region of said insulation layer to form at least one first through hole in said insulation layer;
forming a first layer of the first conductivity type on said insulation layer and on part of said semiconductor substrate exposed in said at least one first through hole;
removing a second region of said first layer and said insulation layer to form at least one second through hole in said insulation layer; and
forming a second layer of an opposite conductivity type on said first layer and on part of said semiconductor substrate exposed in said at least one second through hole.

9. The method of manufacturing the solar cell device according to claim 8, wherein the removing said first region of said insulation layer comprises irradiating said first region with a laser beam to remove said first region.

10. The method of manufacturing the solar cell device according to claim 9, further comprising removing part of said semiconductor substrate to form a recessed portion in communication with said at least one first through hole in said semiconductor substrate.

11. The method of manufacturing the solar cell device according to any one of claims 8 to 10, wherein the removing the second region of said first layer and said insulation layer comprises irradiating the second region of said first layer and said insulation layer with a laser beam to remove the second region of said first layer and said insulation layer.

12. The method of manufacturing the solar cell device according to claim 11, further comprising removing part of said semiconductor substrate to form a recessed portion in communication with said at least one second through hole in said semiconductor substrate.

13. The method of manufacturing the solar cell device according to any one of claims 8 to 12, wherein said at least one first through hole comprises a plurality of first through holes, and said at least one second through hole comprises a plurality of second through holes, said method further comprising:

forming on said first layer a first conductive section for connecting a plurality of first junction regions between said semiconductor substrate and said first layer to each other, said plurality of first junction regions being formed in said plurality of first through holes, respectively; and
forming on said second layer a second conductive section for connecting a plurality of second junction regions between said semiconductor substrate and said second layer to each other, said plurality of second junction regions being formed in said plurality of second through holes, respectively.

14. The method of manufacturing the solar cell device according to claim 13, wherein each of the forming said first conductive section and the forming said second conductive section comprises forming a comb-shaped electrode with a plurality of electrode fingers on said back surface side of said semiconductor substrate, wherein said first through holes are arranged along said electrode fingers of said first conductive section, and wherein said second through holes are arranged along said electrode fingers of said second conductive section.

15. A method of manufacturing a solar cell device, comprising:

preparing a semiconductor substrate of a first conductivity type comprising a light receiving surface and a back surface opposite said light receiving surface;

forming an insulation layer on said back surface side of said semiconductor substrate;

removing a first region of said insulation layer to form a plurality of first through holes in said insulation layer;

removing a second region of said insulation layer to form a plurality of second through holes in said insulation layer;

forming a diffusion layer of an opposite conductivity type near part of said back surface of said semiconductor substrate exposed in said plurality of second through holes; and

forming a first layer of the first conductivity type on said insulation layer and on part of said semiconductor substrate exposed in said plurality of first through holes.

F I G . 1

20A

F I G . 2

(a)

1(8,9)

R

(b)

11a

11

1

12a

12

11b    12b

FIG. 3

EP 2 239 788 A1

F I G . 4

20A

F I G . 5

F I G . 6

(a)

11 — 10a, 10a

12 — 10b, 10b

11 — 10a, 10a

(b)

11 — 10a, 10a

12 — 10b

11 — 10a, 10a

# FIG. 7

(a)

(b)

F I G . 8

(a)

(b)

F I G . 9

(a)

DEPLETION
LAYER

p-TYPE SEMICONDUCTOR
SUBSTRATE

INSULATION LAYER

(b)

1

7

3

FIG. 10

(a)

(b)

7

(c)

10a                                    10a

(d)

3        2a

(e)

6a        5a

(f)

10b

(g)

4        2b

(h)

5b        6b

(i)

4        2b

(j)

1a

(k)

9        8

(l)

11(11b)        12(12b)        11(11b)

F I G . 1 1

101    102          103

LB

104

1

105

FIG. 12

(a)

(b)

F I G . 1 3

(a)

(b)

F I G . 1 4

(a)

(b)

F I G . 1 5

(a)

(b)

(c)

F I G .　1 6

F I G . 1 7

(a)

(b)

(c)

(d)

(e)

(f)

(g)

(h)

(i)

(j)

FIG. 18

F I G . 1 9

(a)

1

(b)

7

(c)

10b

(d)

15

(e) 10a          10a

2
3

(f)

(g) 5a 6a          5b 6b

11(11b)          12 (12b)          11(11b)

## INTERNATIONAL SEARCH REPORT

| International application No. |
| --- |
| PCT/JP2009/051608 |

A. CLASSIFICATION OF SUBJECT MATTER
*H01L31/06(2006.01)i, H01L31/18(2006.01)i*

According to International Patent Classification (IPC) or to both national classification and IPC

B. FIELDS SEARCHED

Minimum documentation searched (classification system followed by classification symbols)
H01L31/00-31/20

Documentation searched other than minimum documentation to the extent that such documents are included in the fields searched

| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2007-59644 A (Toyota Motor Corp.), 08 March, 2007 (08.03.07), (Family: none) | 1-15 |
| A | JP 2005-510885 A (Shell Solar GmbH), 21 April, 2005 (21.04.05), & WO 2003/047005 A2 & EP 1449261 A & US 2005/0016585 A1 & CN 1592972 A & DE 60221426 T & ES 2289168 T | 1-15 |
| A | JP 2001-267610 A (Hitachi, Ltd.), 28 September, 2001 (28.09.01), (Family: none) | 1-15 |

| ☒ Further documents are listed in the continuation of Box C. | ☐ See patent family annex. |

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search 27 March, 2009 (27.03.09) | Date of mailing of the international search report 14 April, 2009 (14.04.09) |

| Name and mailing address of the ISA/ Japanese Patent Office | Authorized officer |
| Facsimile No. | Telephone No. |

Form PCT/ISA/210 (second sheet) (April 2007)

**EP 2 239 788 A1**

| INTERNATIONAL SEARCH REPORT | International application No. |
|---|---|
| | PCT/JP2009/051608 |

C (Continuation).    DOCUMENTS CONSIDERED TO BE RELEVANT

| Category* | Citation of document, with indication, where appropriate, of the relevant passages | Relevant to claim No. |
|---|---|---|
| A | A.Rohatgi, "Designs and Fabrication Technologies for Future Commercial Crystalline Si Solar Cells", 15th Workshop on Crystalline Sillicon Solar Cells & Modules: Materials and Processes, August 7-10, 2005, pp.11-22 | 1-15 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8274356 A

**Non-patent literature cited in the description**

- *13th-EU-PSEC,* 1995, 1582
- *15th-NREL-Workshop,* 2005, 11-22